(19) Europäisches Patentamt
European Patent Office
Office européen des brevets

(11) EP 1 239 330 A1

(12) **EUROPÄISCHE PATENTANMELDUNG**

(43) Veröffentlichungstag:
**11.09.2002 Patentblatt 2002/37**

(51) Int Cl.[7]: **G03F 7/20**

(21) Anmeldenummer: **02008198.0**

(22) Anmeldetag: **26.07.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **30.07.1999 DE 19935568**
**09.09.1999 DE 29915847 U**

(62) Dokumentnummer(n) der früheren Anmeldung(en) nach Art. 76 EPÜ:
**00956287.7 / 1 200 879**

(71) Anmelder: **Carl Zeiss**
**89518 Heidenheim (Brenz) (DE)**

(72) Erfinder: **Schultz, Jörg**
**73430 Aalen (DE)**

(74) Vertreter: **Dr. Weitzel & Partner**
**Friedenstrasse 10**
**89522 Heidenheim (DE)**

Bemerkungen:
Diese Anmeldung ist am 17 - 04 - 2002 als Teilanmeldung zu der unter INID-Kode 62 erwähnten Anmeldung eingereicht worden.

(54) **Steuerung der Beleuchtungsverteilung in der Austrittspupille eines EUV-Beleuchtungssystems**

(57) Die Erfindung betrifft ein Beleuchtungssystem für eine Projektionsbelichtungsanlage, umfassend und ist gekennzeichnet durch die folgenden Merkmale

- eine Lichtquelle (1) zur Emission von Wellenlängen < 193nm, insbesondere von Wellenlängen zwischen 10nm und 20nm;
- einer Objekt- bzw. Retikelebene (39);
- einer zur Objektebene (39) konjugierten Ebene (Z) zwischen Lichtquelle (1) und Objektebene (39);
- Mittel zum Erzeugen sekundärer Lichtquellen, die zwischen der Lichtquelle (1) und der konjugierten Objektebene (Z) angeordnet sind, wobei die Mittel mindestens eine Spiegel- oder Linsenvorrichtung, umfassend mindestens einen Spiegel oder eine Linse (34), der bzw. die in Rasterelemente (10,40,100,102) gegliedert ist, aufweisen, dadurch gekennzeichnet, daß
- am Ort oder nahe am Ort der konjugierten Objektebene (Z) Einrichtungen (200) zum Erzeugen einer vorbestimmten Lichtverteilung in der Austrittspupille (390) des Beleuchtungssystems angeordnet sind

Fig.2o

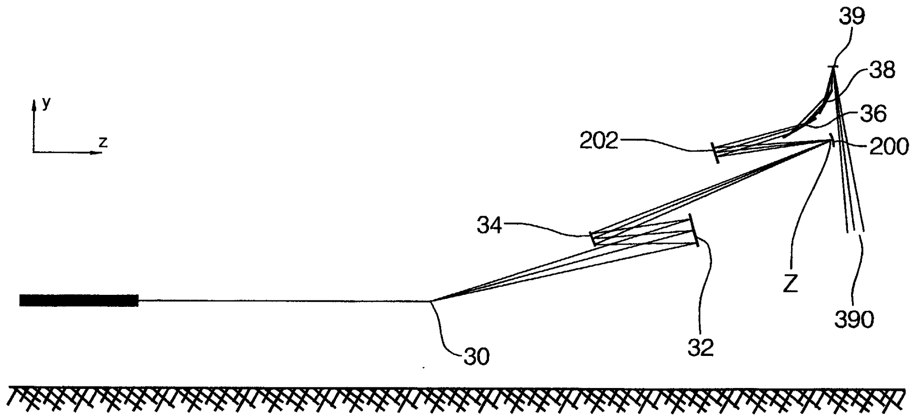


EP 1 239 330 A1

**Beschreibung**

Die Erfindung betrifft ein Beleuchtungssystem, insbesondere ein solches für die Lithographie also beispielsweise VUV und EUV-Lithographie mit Wellenlängen kleiner gleich 193 nm, wobei das Beleuchtungssystem wenigstens eine Lichtquelle, Mittel zum Erzeugen sekundärer Lichtquellen, die einen Spiegel oder Linse mit Rasterelementen zur Erzeugung sekundärer Lichtquellen umfassen, einer realen oder virtuellen Blendenebene sowie einem oder mehreren optischen Elementen zur Abbildung der realen oder virtuellen Blendenebene in die Austrittspupille des Beleuchtungssystems und Mittel zum Erzeugen einer vorbestimmten Lichtverteilung in der Austrittspupille des Beleuchtungssystems sowie ein Beleuchtungssystem für Wellenlängen ≤ 193 nm mit mindestens einer Lichtquelle, einer Objektebene und einer zur Objektebene konjugierten Ebene zwischen Lichtquelle und Objektebene.

Um die Strukturbreiten für elektronische Bauteile noch weiter reduzieren zu können, insbesondere in den Submikron-Bereich, ist es erforderlich, die Wellenlänge des für die Mikrolithographie eingesetzten Lichtes zu verringern.

Denkbar ist bei Wellenlängen kleiner als 193 nm beispielsweise die Lithographie mit weichen Röntgenstrahlen wie sie aus der US 5339346 bekannt geworden ist.

Neben der Beleuchtung gemäß der US 5 339 346, die mindestens vier paarweise symmetrisch zur Quelle angeordnete Spiegelfacetten benötigt, kann man Beleuchtungssysteme vorsehen, die beispielsweise mit Hilfe von reflektiven Wabenplatten zur homogenen Beleuchtung des Ringfeldes eines Belichtungsobjektives arbeiten. Solche Systeme haben den Vorteil, daß das Feld eines Objektives mit möglichst wenigen Reflektionen homogen beleuchtet wird, des weiteren eine feldunabhängige Ausleuchtung der Pupille bis zu einem bestimmten Füllgrad gewährleistet ist.

Reflektive Wabenplatten für EUV-Beleuchtungssysteme sind aus der US 5 581605 bekannt geworden.

Der Offenbarungsgehalt sämtlicher vorgenannter Schriften US 5 339 346 sowie US 5 581 605 wird in vorliegender Anmeldung vollumfänglich mit aufgenommen.

Eine Steigerung von Auflösung und Tiefenschärfe bei VUV und EUV-Beleuchtungssystemen ist möglich, wenn je nach Maskenstruktur, d.h. je nach zu beleuchtendem Retikel, die Ausleuchtung der Maske eingestellt werden kann. Im Stand der Technik erfolgte die Steuerung des Beleuchtungssettings in der Regel mit einer Blende, die dem Spiegel bzw. der Linse mit Rasterelementen nachgeordnet ist. Diesbezüglich wird beispielsweise auf die

US-A 5 526 093
JP-A-100 92 727
JP-A-102 75 771
JP-A-100 62 710
JP-A-090 63 943

verwiesen.

Aus der JP-A-103 031 23 ist ein Beleuchtungssystem mit einer Hg-Lampe für Wellenlängen > 248 nm bekanntgeworden, bei dem vor einem optischen Integrator eine Scanblende angeordnet ist, die eine vorbestimmte Lichtmenge in den optischen Integrator einsteuert, so daß sich in einer Blendenebene eine bestimmte Lichtverteilung ergibt.

Die US-A-5 379 090 zeigt ebenfalls ein Beleuchtungssystem für Wellenlängen > 248 nm mit einer Hg-Lampe. Das System gemäß der US-A-5 379 090 umfaßt ein Vario- bzw. Zoomobjektiv mit dem die Größe der sekundären Lichtquelle eingestellt wird. Zusätzlich wird eine Blende zum Formen der Lichtverteilung auf der zu beleuchtenden Maske eingesetzt.

Aus der US-A-5 363 170 ist ein weiteres Beleuchtungssystem für Wellenlängen > 248 nm mit einer Hg-Lampe bekanntgeworden. Das System gemäß der US-A-5 363 170 umfaßt einen optischen Integrator, der mit Hilfe eines Vario- bzw. Zoomobjektiv variabel ausgeleuchtet wird, um hiermit die sekundären Lichtquellen und damit die Ausleuchtung in der Retikelebene zu beeinflussen.

Die DE-A-197 16 794 zeigt eine Vorrichtung für die Nah-Typ-Mikrolithographie2, die für Wellenlängen > 248 nm ausgelegt ist, mit einem optischen Integrator und einem optischen System zur Strahlformung. Das optische System zur Strahlformung ist vor dem optischen Integrator angeordnet und dient dazu ein elliptisches Querschnittsprofil zu formen, welches dem elliptischen Profil der Apertur angepasst ist.

Die US 5 305 054 zeigt ein weiteres Beleuchtungssystem für Wellenlängen > 248 nm mit einem optischen Integrator. Bei dem System gemäß der US 5 305 054 sind vor dem optischen Integrator Mittel zur Aufspaltungen des Lichtstrahles in vier Lichtbündel zur Ausbildung einer quadropolaren Beleuchtung vorgesehen.

Sämtliche Systeme im Stand der Technik für Wellenlängen > 248 nm zeichnen sich durch die Verwendung rein reflektiver optischer Komponenten aus, insbesondere umfassen die aus diesen Systemen bekanntgewordenen optischen Integratoren refraktive Wabenkondensoren.

Aus der US 5 896 438 ist ein EUV-Beleuchtungssystem mit Undulator-Lichtquelle bekannt geworden, bei dem mittels eines Scan-Spiegels ein optischer Integrator mit reflektiven Rasterelementen ausgeleuchtet werden kann. Die reflektiven Rasterelemente des aus der US 5 896 438 bekanntgewordenen optischen Integrators weisen ein geringes Waben-Aspekt-Verhältnis auf und sind quadratisch. Aufgabe des Scan-Spiegels bei dieser Beleuchtungs-Einrichtung ist eine Kohärenzerhöhung durch einen Winkel-Scan des EUV-Lichtstrahles. Inwieweit durch das Einbringen eines Scan-Spiegels die Qualität der Maskenbeleuchtung, das heißt der Beleuchtung des Retikels beeinflußt wird, ist aus der US 5 896 438 nicht bekannt geworden.

Der Offenbarungsgehalt der US 5 896 438 wird in den Offenbarungsgehalt der vorliegenden Anmeldung vollumfänglich mit aufgenommen.

Aus der nachveröffentlichten Druckschrift

WO 99/57732

sind EUV-Beleuchtungssysteme mit Spiegeln umfassend eine Vielzahl von Rasterelementen bekanntgeworden, die Mittel zum Erzeugen einer vorbestimmten Lichtverteilung in der Austrittspupille umfassen.

Nachteilig an den EUV-System aus dem Stand der Technik war, daß die Steuerung der Lichtverteilung in der Blendenebene mit Masken mit einem beträchtlichen Lichtverlust verbunden war oder eine vorgebbare Uniformität in der Objekt- bzw. Retikelebene nicht erreicht wurde, weil die Durchmischung oder die Zahl der ausgeleuchteten Waben zu gering war.

Aufgabe der Erfindung ist es, ein EUV-Beleuchtungssystem anzugeben, mit dem die zuvor angegebenen Nachteile im Stand der Technik vermieden werden können. Insbesondere soll für beliebige VUV- und EUV-Quellen ein System angegeben werden, bei dem die Steuerung der Lichtverteilung in der Austrittspupille des Beleuchtungssystems bei gleichzeitig homogener Ausleuchtung der Objekt- bzw. Retikelebene möglich ist.

In einer ersten Ausgestaltung der Erfindung wird bei einem EUV-Beleuchtungssystem vorgesehen, daß mit Hilfe der Mittel zum Erzeugen einer vorbestimmten Beleuchtungsverteilung in der Austrittspupille eine derartige Anzahl von Rasterelementen ausgeleuchtet werden, daß eine vorbestimmte Uniformität in der Objektebene erreicht wird.

In einer alternativen Ausgestaltung der Erfindung wird bei einem Beleuchtungssystem das eine zur Objektebene konjugierte Ebene aufweist vorgesehen die Mittel zum Erzeugen einer vorbestimmten Lichtverteilung nahe oder in der zur Objektebene konjugierten Ebene anzuordnen.

Als Lichtquellen für EUV-Beleuchtungssysteme werden derzeit diskutiert:

Laser-Plasma-Quellen
Pinch-Plasma-Quellen
Synchrotron-Strahlungsquellen

Bei Laser-Plasma-Quellen wird ein intensiver Laserstrahl auf ein Target (Festkörper, Gasjet, Tröpfchen) fokussiert. Durch die Anregung wird das Target so stark erhitzt, daß ein Plasma entsteht. Dieses emittiert EUV-Strahlung.

Typische Laser-Plasma-Quellen weisen eine kugelförmige Abstrahlung auf, d.h. einen Abstrahlwinkelbereich von 4 $\pi$ sowie einen Durchmesser von 50 $\mu$m - 200 $\mu$m.

Bei Pinch-Plasma-Quellen wird das Plasma über elektrische Anregung erzeugt.

Pinch-Plasma-Quellen lassen sich als Volumenstrahler (ø = 1.00 mm) beschreiben, die in 4$\pi$ abstrahlen, wobei die Abstrahlcharakteristik durch die Quellgeometrie gegeben ist.

Bei Synchrotronstrahlungsquellen kann man derzeit drei Arten von Quellen unterscheiden:

- Bending-Magneten
- Wiggler
- Undulatoren

Bei Bending-Magnet-Quellen werden die Elektronen durch einen Bending-Magneten abgelenkt und Photonen-Strahlung emittiert.

Wiggler-Quellen umfassen zur Ablenkung des Elektrons bzw. eines Elektronenstrahles einen sogenannten Wiggler, der eine Vielzahl von aneinandergereihten abwechselnd gepolten Magnetpaaren umfaßt. Durchläuft ein Elektron einen Wiggler, so wird das Elektron einem periodischen, vertikalen Magnetfeld ausgesetzt; das Elektron oszilliert dementsprechend in der horizontalen Ebene. Wiggler zeichnen sich weiter dadurch aus, daß keine Kohärenzeffekte auftreten. Die mittels eines Wigglers erzeugte Synchrotronstrahlung ähnelt der eines Bending-Magneten und strahlt in einen horizontalen Raumwinkel ab. Sie weist im Gegensatz zum Bending-Magneten einen um die Anzahl der Pole des Wigglers verstärkten Fluß auf.

Der Übergang von Wiggler-Quellen zu Undulator-Quellen ist fließend.

Bei Undulator-Quellen werden die Elektronen im Undulator einem Magnetfeld mit kürzerer Periode und geringerem Magnetfeld der Ablenkpole als beim Wiggler ausgesetzt, so daß Interferenz-Effekte der Synchrotronstrahlung auftreten. Die Synchrotronstrahlung weist aufgrund der Interferenzeffekte ein diskontinuierliches Spektrum auf und strahlt sowohl horizontal wie vertikal in ein kleines Raumwinkelelement ab; d.h. die Strahlung ist stark gerichtet.

Betreffend den prinzipiellen Aufbau von EUV-Beleuchtungssystemen wird auf die anhängigen Anmeldungen EP 99106348.8, eingereicht am 2.03.1999, mit dem Titel "Beleuchtungssystem, insbesondere für die EUV-Lithographie", US-Serial No. 09/305,017, eingereicht am 04.05.1999 mit dem Titel "Illumination system particularly for EUV-Lithography" sowie WO99/57732, eingereicht am 04.05.1999, mit dem Titel "Beleuchtungssystem, insbesondere für die EUV-Lithographie" der Anmelderin verwiesen, deren Offenbarungsgehalt vollumfänglich in die vorliegende Anmeldung mitaufgenommen wird.

In einer vorteilhaften Ausgestaltung der Erfindung ist vorgesehen, daß die Mittel zur Erzeugung der Lichtverteilung einen Scan-Spiegel wie beispielsweise in der US 5 896 438 umfassen. Bevorzugt ist ein derartiger Scan-Spiegel ansteuerbar. Die Verwendung eines Scan-Spiegels hat den Vorteil einer verlustfreien Steuerung der Beleuchtungsverteilung. Insbesondere bietet sich die Verwendung eines Scan-Spiegels bei Lichtquellen mit kleinem Lichtleitwert, beispielsweise Undulator-Lichtquellen an, wobei bei derartigen Systemen Scan-Spiegel zur Erhöhung des Lichtleitwertes eingesetzt werden.

Bei einem System ohne zur Objektebene konjugierten Ebene zwischen Lichtquelle und Objektebene kann durch eine entsprechende Steuerung der Scan-Bewegung der Spiegel mit den Rasterelementen zur Erzeugung sekundärer Lichtquellen entsprechend ausgeleuchtet werden. Alternativ zu einem Scan-Spiegel kann vorgesehen sein, daß vor dem Spiegel mit Rasterelementen ein optisches System mit Zoom-Wirkung angeordnet ist. Mit einem derartigen optischen System können variable Brennweiten durch Verschieben einzelner optischer Komponenten bei konstanter Bildebene, die hier die Ebene des Spiegels mit Rasterelementen ist, beleuchtet werden.

In einer weiteren vorteilhaften Ausführungsform der Erfindung für Systeme ohne konjugierte Ebene zur Objektebene ist vorgesehen, daß zur Erzeugung einer Lichtverteilung vorbestimmter Größe die gesamte Kollektoreinheit bestehend aus optischen Elementen positiver und/oder negativer Brechkraft, beispielsweise aus Zerstreuspiegel und Sammellinse ausgetauscht wird.

Hierdurch ergibt sich beispielsweise die Möglichkeit, einen größeren oder kleineren Kreis auf dem Spiegel mit Rasterelementen, die als Feldwabenplatte ausgebildet sein kann, auszuleuchten.

Sowohl für Systeme ohne wie mit einer zur Objektebene konjugiertene Ebene können die Mittel zur Erzeugung einer vorbestimmten Lichtverteilung in einer weiteren Ausgestaltung der Erfindung einen Spiegel oder eine Linse mit deformierbarer Oberfläche umfassen.

Spiegel mit deformierbarer Oberfläche sind beispielsweise aus der JP-A-5100097 oder der US-A-5825844 bekanntgeworden, wobei der Offenbarungsgehalt vorgenannter Schrift in die vorliegende Anmeldung vollumfänglich mitaufgenommen wird.

Bei der JP-A-5100097 wird die Oberflächendeformation mit Hilfe von Piezo-Kristallen angeregt. Dabei werden an der Unterseite des Spiegels eine Vielzahl von Manipulatoren angebracht. Aus der US-A-5825844 ist neben einer Anregung mit Piezo-Kristallen auch eine elektromagnetische Anregung bekanntgeworden.

Der deformierbare Spiegel zum Erzeugen einer vorbestimmten Lichtverteilung in der Austrittspupille kann beispielsweise in der Kollektoreinheit angeordnet sein; bei Beleuchtungssystemen mit Zwischenbild, d.h. mit einer zur Objektbzw. Retikelebene konjugierten Ebene kann der deformierbare Spiegel auch in dieser Ebene angeordnet sein.

Für die Lichtverteilung in der Austrittspupille ergeben sich eine Vielzahl von Möglichkeiten. In einer ersten Ausführungsform der Erfindung ist vorgesehen, daß die Austrittspupille kreisförmig ausgeleuchtet wird. Alternativ zu einer kreisrunden Ausleuchtung kann eine ringförmige Ausleuchtung oder eine Quadropol-Beleuchtung vorgesehen sein.

Um bei Systemen, bei denen das Feld ein hohes Aspektverhältnis aufweist, die Uniformität der Feldausleuchtung sicherzustellen, ist mit Vorteil vorgesehen, daß die Rasterelemente des Spiegels oder Linse zur Erzeugung sekundärer Lichtquellen Feldwaben mit einem geringeren Aspektverhältnis als das Feld umfassen und beispielsweise zylinder- und/oder toroidförmig ausgebildet sind. Dadurch wird die Zahl der unvollständig ausgeleuchteten Feldwaben verringert. Bezüglich der Wirkung derartiger Systeme wird auf die anhängige Anmeldung DE-A-199 31 848.4, eingereicht am 09.07.1999, mit dem Titel "Komponenten mit anamorphotischer Wirkung zur Reduzierung des Waben-Aspektverhältnisses bei EUV-Beleuchtungssystemen" verwiesen, deren Offenbarungsgehalt vollumfänglich in die vorliegende Anmeldung mit aufgenommen wird.

Die mit Hilfe der erfindungsgemäßen Vorrichtung erreichbare Uniformität der Intensitätsverteilung innerhalb eines vorgegebenenen Feldes in der Objektbzw. Retikelebene ist $< 10$ %, vorzugsweise $< 5$ %, besonders bevorzugt $< 1$ %. Während bei Steppersystemen die Uniformität der Intensitätsverteilung innerhalb eines vorgegebenen Feldes betrachtet wird, muß bei Scanner-Systemen die Uniformität der Scan-Energie für jeden Feldpunkt senkrecht zur Scan-Richtung gegeben sein.

Neben dem Beleuchtungssystem stellt die Erfindung auch eine EUV-Projektionsanlage mit einem derartigen Beleuchtungssystem zur Verfügung sowie ein Verfahren zur Herstellung mikroelektronischer Bauelemente.

Nachfolgend soll die Erfindung anhand von Ausführungsbeispielen näher beschrieben werden.

Es zeigen:

Fig. 1A und 1B: prinzipieller Aufbau eines Beleuchtungssystems mit einer Undulator-Einheit als Lichtquelle;

Fig. 2A: Ausgestaltung eines Aufbaues gemäß Figur 1A beziehungsweise 1B;

Fig. 2B: Ausgestaltung eines Aufbaus gemäß Fig. 1A beziehungsweise 1B mit einem Scan-Spiegel;

Fig.2C-2D: Ausgestaltung eines Aufbaues gemäß Figur 1A beziehungsweise 1B mit einem deformierbaren Spiegel in der Kollektoreinheit für zwei Zustände des deformierbaren Spiegels.

Fig. 2E Beleuchtungssystem mit einem zweiten Spiegel mit Rasterelementen.

Fig. 2F Beleuchtungssystem mit einem zweiten Spiegel mit Rasterelementen, wobei der zweite Spiegel mit Rasterelementen verschieden von dem in Fig. 2E gezeigten ist.

Fig. 2G und Fig. 2H: Ausschnitte aus dem System gemäß Fig. 2E bzw. Fig. 2F

Fig. 21 und Fig. 2K: Frontalansicht des zweiten Spiegels mit Rasterelementen gemäß Fig. 2E und Fig. 2F

Fig. 2M und Fig. 2N: mögliche Ausführungsformen eines Spiegels zur Erzeugung einer Quadropol-Beleuchtung

Fig. 2O: Beleuchtungssystem mit Zwischenbild, wobei der deformierbare Spiegel in der zur Retikelebene konjugierten Ebene angeordnet ist.

Fig. 2P: Ausschnitt des zusätzlichen Spiegels mit einer Anzahl von auf der Spiegeloberfläche angeordneten Feldwaben.

Fig. 2Q: Seitenansicht des zusätzlichen Spiegels mit Feldwaben.

Fig. 3: Beispiel für einen Spiegel mit darauf angeordneten Rasterelementen;

Fig. 4A: Verteilung der sekundären Lichtquelle in der Blendenebene bei einem Spiegel gemäß Figur 3;

Fig. 4B-4M: eine Ausführungsform eines EUV-Beleuchtungssystems mit Wiggler-Quelle;

Fig. 5: Zusammenhang zwischen Objektivapertur und Ausleuchtung zur Definition des Füllfaktors;

Fig. 6A: Ausleuchtung der Feldwabenplatte mit einem Füllfaktor $\sigma = 1{,}0$;

Fig. 6B: Ausleuchtung der Feldwabenplatte mit einem Füllfaktor $\sigma = 0{,}6$;

Fig. 6C: annulare Ausleuchtung der Feldwabenplatte mit einem Füllfaktor

$$\frac{\sigma_{out}}{\sigma_{in}} = \frac{1{,}0}{0{,}7}$$

Fig. 6D: Beleuchtung der Feldwabenplatte bei Quadrupol-Beleuchtung;

Fig. 7: Pupillenausleuchtung bei $\sigma = 1{,}0$ für den Feldpunkt auf der optischen Achse;

Fig. 8: Pupillenausleuchtung bei $\sigma = 1{,}0$ für einen Feldpunkt am Feldrand ($x = 40, y = 4{,}04$);

Fig. 9: Pupillenausleuchtung bei $\sigma = 0{,}6$ für den Feldpunkt auf der optischen Achse;

Fig. 10: Pupillenausleuchtung bei $\sigma = 0{,}6$ für einen Feldpunkt am Feldrand ($x = 40$, $Y = 4{,}04$);

Fig. 11: Pupillenausleuchtung bei annularer Ausleuchtung für einen Feldpunkt auf der optischen Achse;

Fig. 12: Pupillenausleuchtung bei annularer Ausleuchtung für einen Feldpunkt am Feldrand (x = 40,y = 4,04);

| | |
|---|---|
| Fig. 13: | Pupillenausleuchtung bei quadrupolarer Ausleuchtung für einen Feldpunkt auf der optischen Ebene; |
| Fig. 14: | Pupillenausleuchtung bei quadrupolarer Ausleuchtung für einen Feldpunkt am Feldrand (x = 40,y = 4,04); |
| Fig. 15: | integrale Scan-Energie in der Retikelebene bei einer Beleuchtungsverteilung mit σ=1,0 in der Austrittspupille; |
| Fig. 16: | integrale Scan-Energie in der Retikelebene bei einer Beleuchtungsverteilung mit σ=0,6 in der Austrittspupille; |
| Fig. 17: | integrale Scan-Energie in der Retikelebene für eine annulare Beleuchtungsverteilung; |
| Fig. 18: | integrale Scan-Energie in der Retikelebene bei quadropolarer Beleuchtungsverteilung. |
| Fig. 19: | System mit Waben mit einem Aspektverhältnis von 17,5 : 1 angeordnet auf einer Wabenplatte. |
| Fig. 20: | Lichtverteilung in der Blendenebene des Beleuchtungssystems bei einer Anordnung der Feldwaben auf der Wabenplatte gem. Fig. 19. |
| Fig. 21: | Feldwabenplatte mit Waben mit einem Aspektverhältnis von 17,5 : 1. |
| Fig. 22: | Feldwabenplatte mit Waben mit einem Aspektverhältnis von 1 : 1. |

In den Figuren 1A und 1B wird beispielhaft der prinzipielle Aufbau eines EUV-Beleuchtungssystems mit einer Synchrotron-Strahlungslichtquelle, die vorliegend als Undulator ausgebildet ist, gezeigt, ohne daß die Erfindung hierauf beschränkt ist.

Undulator-Quellen weisen in der ausgezeichneten Ebene in die das vorbestimmte Wellenlängenspektrum abgestrahlt wird, eine Strahldivergenz < 100 mrad, vorzugsweise < 50 mrad auf. Handelt es sich bei der Lichtquelle um eine ausgedehnte Quelle, so kann es erforderlich werden, am Ort der sekundären Lichtquellen einen zweiten Spiegel oder eine zweite Linse mit Rasterelementen vorzusehen, um die Rasterelemente des ersten Spiegels oder Linse korrekt in die Retikelebene abzubilden. Die Rasterelemente des ersten Spiegels oder der ersten Linse werden als Feldwaben bezeichnet, die Rasterelemente des zweiten Spiegels oder der zweiten Linse als Pupillenwaben.

In den Figuren 1A und 1B ist ein EUV-Beleuchtungssystem in einer refraktiven Darstellung zur prinzipiellen Erläuterung des Systems gezeigt. Die Strahlaufweitung des von der Strahlungsquelle 1 emittierten Strahles geschieht vorliegend mit Hilfe einer Zerstreulinse 3 bzw. Zerstreuspiegel ohne hierauf beschränkt zu sein.

Betreffend den Aufbau von Beleuchtungssystemen wird auf die anhängigen Anmeldungen EP 99106348.8, einreicht am 02.03.1999, mit dem Titel "Beleuchtungssystem, insbesondere für die EUV-Lithographie", US-Serial No. 09/305,017, eingereicht am 04.05.1999, mit dem Titel "Illumination system particulary for EUV-Lithography" sowie WO99/57732, eingereicht am 04.05.1999, mit dem Titel "Beleuchtungssystem, insbesondere für die EUV-Lithographie" der Anmelderin verwiesen, deren Offenbarungsgehalt vollumfänglich in die vorliegende Anmeldung mitaufgenommen wird.

Die sammelnde Wirkung zur Erzeugung der sekundären Lichtquelle 12 wird durch den der Zerstreulinse bzw. dem Zerstreuspiegel 3 nachgeordneten Sammelspiegel bzw. Sammellinse 5 aufgebracht. Die Mittel zur Strahlaufweitung und der Spiegel bzw. die Linse mit sammelnder Wirkung bilden eine sogenannte Kollektoreinheit bzw. ein Kollektorsystem 7 aus. Ohne Spiegel mit Rasterelementen würde der Sammelspiegel 5 die Quelle 1 in die Bildebene 9 des Beleuchtungssystems, wie in Fig. 1A gezeigt, auf die sekundäre Lichtquelle 12 abbilden. Mit dem Spiegel mit Rasterelementen 10 bzw. dem Facettenspiegel wird die sekundäre Lichtquelle 12 in eine Vielzahl von sekundären Lichtquellen 14 zerlegt, so daß eine Vielzahl von sekundären Lichtquellen 14 in der Blendenebene 16 erzeugt werden, wie in Figur 1B dargestellt. Die Rasterelemente 10 weisen dabei sammelnde Wirkung auf. Die Rasterelemente 10 des ersten Spiegels werden nachfolgend auch als Feldwaben bezeichnet.

Werden die in den Figuren 1A und 1B als refraktive Systeme aufgezogenen Beleuchtungssysteme beispielsweise für EUV-Strahlung ausgelegt, so müssen diese für die 13 nm-Strahlung reflektiv und aufgrund der hohen Reflektionsverluste mit möglichst wenigen Reflektionen umgesetzt werden.

Für eine Undulator-Quelle kann die Kollektoreinheit bei 13 nm-Strahlung aus einem ersten grazing incidence Spiegel oder einem Scanspiegel, der die Strahlung aufweitet, und einem zweiten normal incidence Spiegel, der wieder sammelnd auf die Strahlung wirkt, bestehen. Der Vorteil des Scan-Spiegels liegt darin, daß hiermit die Größe der Ausleuchtung variiert werden kann.

Um zu einem vorteilhaften Design bei 13 nm Wellenlänge zu gelangen, sind aufgrund der höheren Reflektivität grazing incidence Spiegel ($R \approx 80$ %) normal incidence Spiegeln ($R \approx 65$ %) vorzuziehen.

Vorteilhafterweise strahlt die Quelle in horizontaler Richtung ab.

Die den Spiegeln mit Rasterelementen nachgeordneten optischen Elemente dienen dazu, die Blendenebene des Beleuchtungssystems in die Austrittspupille des Beleuchtungssystems, die vorliegend mit der Eintrittspupille des Projektionsobjektives zusammenfällt, abzubilden und das Ringfeld zu formen. Des weiteren dienen sie dazu, die Beleuchtungsverteilung entsprechend den Anforderungen zu erzeugen.

Bei Stepper-Systemen wird eine Uniformität der Intensitätsverteilung innerhalb eines vorgegebenen Feldes < 10 %, vorzugsweise < 5 %, besonders bevorzugt < 1 %, gefordert.

Für die Uniformität der Intensitäts-Verteilung E(x,y) gilt

$$Uniformität = \frac{E_{max}-E_{min}}{E_{max}+E_{min}} x 100\%$$

wobei $E_{max}$ die maximale und $E_{min}$ die minimale Intensität innerhalb des vorgegebenen Feldes sind.

Bei Scanner-Systemen wird eine Uniformität der Scan-Energie < 10 %, bevorzugt < 5 %, besonders bevorzugt < 1 %, gefordert. Die Scan-Energie SE(x) ergibt sich als Linienintegral:

$$SE(x) = \int E(x,y)dy$$

wobei E (x,y) die Intensitätsverteilung in der x-y-Ebene ist,
entlang der Scan-Richtung, die beispielsweise die y-Richtung ist. Jeder Punkt auf dem Wafer enthält entsprechend seiner x-Koordinate die Scan-Energie SE(x).

Für die Uniformität der Scan-Energie gilt:

$$Uniformität = \frac{SE_{max}-SE_{min}}{SE_{max}+SE_{min}} x 100\%$$

wobei $SE_{max}$ die maximale und $SE_{min}$ die minimale Scan-Energie entlang des Scan-Weges bezeichnet.

In Figur 2A ist in schematischer Darstellung ein Beleuchtungssystem für 13 nm-Strahlung mit einer Synchrotron-Strahlungsquelle, in diesem Fall einem Undulator, gezeigt.

Das System besteht aus einem Kollektorspiegel 30, der als grazing incidence Toroidspiegel, der das Strahlbüschel aufweitet, ausgebildet ist und einem normal incidence Kollektorspiegel 32, der den Spiegel mit Rasterelementen 34 ausleuchtet.

Die Feldspiegel 36, 38 sind als grazing incidence Feldspiegel ausgebildet. Sie formen das Feld in der Retikelebene 39 und bilden die Blendenebene in die Austrittspupille ab.

In Fig. 2B ist dieselbe Anordnung wie in Fig 2A gezeigt, jedoch ist der Spiegel 30, als Scan-Spiegel zur variablen Ausleuchtung des Spiegels mit Rasterelementen bzw. Feldwaben 34 ausgebildet.

In Figur 2C und 2D ist eine schematische Darstellung eines Beleuchtungssystem gemäß Figur 1A beziehungsweise 1B ohne Zwischenbild gezeigt, bei dem der Kollektorspiegel 30, der den von der Synchrotron-Strahlungsquelle beispielsweise einer Undulator-Quelle kommenden Strahl aufweitet, ein Spiegel mit deformierbarer Oberfläche ist.

Dadurch läßt sich die Ausleuchtung auf dem Kollektorspiegel 32 und damit auch auf dem Spiegel 34 mit Feldwaben steuern. Beispielshaft soll nachfolgend die Variation der Beleuchtungsverteilung für ein Beleuchtungssystem mit Undulator-Quelle aufgezeigt werden. Die Undulator-Quelle strahlt mit einer horizontalen Divergenz von ±1mrad und einer vertikalen Divergenz von ±0.3mrad ab. Im Abstand von 5000 mm befindet sich der Kollektorspiegel 30. Der Kippwinkel des Kollektrospiegels 30 beträgt 80°. Nach 3000 mm folgt der Kollektorspiegel 32, dessen Kippwinkel 5° beträgt. Die Feldwabenplatte d. h. der Spiegel mit Feldwaben 34 befindet sich im Abstand von 650 mm vom Kollektorspiegel 32. Um die Eintrittspupille des nachfolgenden Objektivs voll zu füllen, das heißt $\sigma = 1.0$ muß die Feldwabenplatte 34 bis zu einem Durchmesser von 64 mm ausgeleuchtet sein. Dies entspricht dem Zustand in Figur 2 C.

Um eine vollständige Füllung von σ = 1.0 zu erreichen sind bei den zuvor beschriebenen Beleuchtungssystem torische Kollektorspiegel 30, 32 mit nachfolgenden Radien erforderlich:

| | $R_x$ [mm] | $R_y$ [mm] |
|---|---|---|
| Kollektorspiegel 30 | -156.6 (zerstreuend) | -1373.5 (zerstreuend) |
| Kollektorspiegel 32 | 3138.0 (sammelnd) | 2967.9 (sammelnd) |

Um zum Beispiel einen Füllgrad von σ = 0.3 zu erzielen, muß der ausgeleuchtete Durchmesser auf 19,2 mm reduziert werden. Dies entspricht dem Zustand in Figur 2 D. Dazu müssen die Radien des Kollektorspiegels 30 durch geeignete Manipulatoren folgendermaßen geändert werden:

| | $R_x$ [mm] | $R_y$ [mm] |
|---|---|---|
| Kollektorspiegel 30 | -985.0 (zerstreuend) | -5241.0 (zerstreuend) |
| Kollektorspiegel 32 | 3138.0 (sammelnd) | 2967.9 (sammelnd) |

Während die Radien des Kollektorspiegels 30 verändert werden, bleiben die Radien des Kollektrospiegels 32, unverändert.

Ist der Kollektorspiegel 30 als Spiegel mit deformierbarer Oberfläche ausgestaltet, so kann durch Deformation der Oberfläche innerhalb der oben angegebenen Radien jeder beliebige Füllgrad zwischen σ = 0.3 und σ = 1.0 eingestellt werden. Dabei sind die Oberflächen nicht auf rein torische Flächen beschränkt. Durch Einbringen von konischen oder höheren asphärischen Flächenanteilen ist es zudem möglich, die Abbildungseigenschaften zu verändern.

Die Deformation ist zum Beispiel durch eine Vielzahl von Manipulatoren an der Unterseite des Spiegels möglich. Die Manipulatoren können Piezoelemente und/oder Elemente für eine elektromagnetische Anregung umfassen.

Möglich ist beispielsweise, den Kollektorspiegel 30 auszutauschen. Mit Wechseloptiken läßt sich so jeder Füllgrad zwischen σ = 0,3 und σ = 1,0 einstellen. Durch Austausch nur eines Kollektorspiegels 30 kann damit die Ausleuchtung der Austrittspupille variiert werden.

Ein weiteres Ausführungsbeispiel zeigt Fig. 2E in schematischer Darstellung. Von der Funktionsweise her gesehen gleiche Bauteile wie in den Figuren 2C und 2D sind mit den gleichen Bezugszeichen versehen. Das Licht der Undulator-Lichtquelle 1 wird von dem zerstreuenden Kollektorspiegel 30 aufgeweitet. Das aufgeweitete Strahlenbüschel 370 beleuchtet einen Spiegel 310 mit Rasterelementen, der nach dem Kollektorspiegel 30 eingefügt wird. Neben dem Spiegel 34 mit Feldwaben gibt es somit einen weiteren Spiegel 310 mit Rasterelementen. Die Rasterelemente des Spiegels 310 zerlegen das einfallende Strahlenbüschel 360 in einzelne Strahlenbüschel 370, wobei in Fig. 2E exemplarisch nur ein Strahlenbüschel 370 für ein einzelnes Rasterelement eingezeichnet ist. Ein konkaver Kondensorspiegel 302 überlagert die einzelnen Strahlenbüschel 370 auf dem Spiegel 34 mit Feldwaben. Dadurch läßt sich eine sehr homogene Ausleuchtung des Spiegels 34 mit Feldwaben erzielen. In der Konfiguration nach Fig. 2E wird dabei der Spiegel 34 Feldwaben vollständig ausgeleuchtet. Da durch den Einsatz des zusätzlichen Spiegels 310 mit Rasterelementen die auf den Spiegel 34 mit Feldwaben treffenden Lichtstrahlen eine größere Divergenz aufweisen als ohne den Einsatz des Spiegels 310, wird nach dem Spiegel 34 mit Feldwaben ein weiterer Spiegel 350 mit Rasterelementen eingefügt. Dieser Spiegel 350 befindet sich am Ort der von den Feldwaben erzeugten sekundären Lichtquellen. Die Rasterelemente des Spiegels 350, die als Pupillenwaben bezeichnet werden, bilden die Feldwaben in die Retikelebene 39 ab. Das Strahlenbüschel 370 wird am Retikel 39 reflektiert und ist bis zur Austrittspupille 390 des Beleuchtungssystems eingezeichnet, die gleichzeitig Eintrittspupille eines nachfolgenden Projektionsobjektives ist, das in Fig. 2E nicht dargestellt ist. Die Beleuchtungsapertur am Retikel 39, bzw. die Ausleuchtung der Austrittspupille 390 hängen dabei direkt von der Ausleuchtung des Spiegels 34 mit Feldwaben ab.

Die Ausleuchtung des Spiegels 34 mit Feldwaben wiederum ist durch den Spiegel 310 mit Rasterelementen gegeben. Dieser ist austauschbar, um die Ausleuchtung der Austrittspupille 390 verändern zu können. Der Spiegel 310 kann manuell, über ein Wechselrad oder mit Hilfe eines Roboterarms ausgetauscht werden. Durch Tausch eines einzelnen optischen Elements kann somit die Ausleuchtung in der Austrittspupille 390 geändert werden. In Fig. 2F ist ein von Spiegel 310 verschiedener Spiegel 320 mit Rasterelementen eingesetzt, der den Spiegel 34 mit Feldwaben nur zum Teil ausleuchtet. Damit ist auch die Apertur am Retikel 39 im Vergleich zu Fig. 2E und die Ausdehnung der Ausleuchtung der Austrittspupille 390 reduziert.

Die Funktionsweise der Spiegel 310 und 320 mit Rasterelementen wird anhand der Fig. 2G und Fig. 2H näher erläutert. Fig. 2G und Fig. 2H zeigen einen Ausschnitt aus dem Beleuchtungssystem der Fig. 2E und Fig. 2F, wobei die Bezugszeichen übernommen wurden. In Fig. 2G trifft das Strahlenbüschel 360 auf den Spiegel 310 mit Rasterelementen 312 und leuchtet diesen vollständig aus. Die Rasterelemente 312 sind in der Ausführung der Fig. 2G konkav ausgebildet. Jedes Rasterelement erzeugt ein Bild der Lichtquelle 1, also eine sekundäre Lichtquelle am Ort des Fokus 372. Nach diesem Fokus divergiert das Strahlenbüschel wieder Richtung Kondensorspiegel 302. Der Kondensorspiegel 302 bildet die Rasterelemente 312 auf den Spiegel 34 mit Feldwaben ab und überlagert die einzelnen Bilder der Rasterelemente 312. Dabei wird jedes einzelne Rasterelement 312 auf die gesamte ausgeleuchtete Fläche des Spiegels 34 mit Feldwaben abgebildet. Die Form der Ausleuchtung auf dem Spiegel 34 mit Feldwaben entspricht dabei der Außenform der Rasterelemente 312.

In Fig. 2H wurde der Spiegel 310 mit Rasterelementen 312 durch den Spiegel 320 mit Rasterelementen 322 ausgetauscht. Während die Brennweite der Rasterelemente 312 und 322 gleich groß ist, wurde die Größe der Rasterelemente verringert. Somit weist der Spiegel 320 mehr Rasterelemente als Spiegel 310 auf. Durch die geringere Größe ist auch die ausgeleuchtete Fläche auf dem Spiegel 34 mit Feldwaben geringer.

Die Rasterelemente 312 und 322 können auch konvex ausgebildet sein. Dann ergeben sich virtuelle sekundäre Lichtquellen 372 und 382. Neben Rasterelementen mit konkaven oder konvexen Oberflächen können auch diffraktive Rasterelemente zum Einsatz kommen. Aufgrund der Anordnung in einem Zick-Zack-Strahlengang können die einzelnen Rasterelemente 312 und 322 wie auch der Kondensorspiegel 302 zur Korrektur der Dezentrierungsfehler eine anamorphotische Wirkung aufweisen, z.B. in Form von torischen Oberflächen.

Da die Rasterelemente 312 und 322 bereits sekundäre Lichtquellen erzeugen, sind die von den Feldwaben des Spiegels 34 erzeugten sekundären Lichtquellen streng genommen tertiäre Lichtquellen. Je nach Anzahl der beleuchteten Rasterelemente 312 und 322 werden die ohne Spiegel 31 und 320 erzeugten sekundären Lichtquellen in die gleiche Anzahl von tertiären Lichtquellen aufgespalten. Im Folgenden wird dennoch im Falle der tertiären Lichtquellen von sekundären Lichtquellen gesprochen, da sie Bilder der Lichtquelle darstellen.

Die Rasterelemente 312 und 322 der Spiegel 310 und 312 können auf dem Spiegel 310 und 320 auch einzeln gekippt angeordnet sein. Dies ist erforderlich, wenn das eintreffende Strahlenbüschel 360 nicht als paralleles Strahlenbüschel auf die Spiegel 310 und 320 trifft. Befindet sich der vordere Brennpunkt des Kondensorspiegels 302 am Ort der sekundären Lichtquellen 372, so trifft das Strahlenbüschel 370 als paralleles Strahlenbüschel auf den Spiegel 34 mit Feldwaben. Befindet sich der hintere Brennpunkt des Kondensorspiegels 302 am Ort des Spiegel 34 mit Feldwaben, so werden die Bilder der Rasterelemente 312 korrekt überlagert.

Das Strahlenbüschel 370 muß nicht als paralleles Strahlenbüschel auf den Spiegel 34 mit Feldwaben treffen. Die optische Wirkung des Kondensorspiegels 302 kann so ausgelegt werden, daß das Strahlenbüschel 370 konvergent auf den Spiegel 34 mit Feldwaben trifft. Dadurch kann erreicht werden, daß die Bilder der Feldwaben in der Retikelebene 39 ohne den Einsatz einer Kondensorlinse zwischen Spiegel 34 mit Feldwaben und Retikelebene 39 überlagert werden. Alternative ist auch denkbar, daß die einzelnen Feldwaben einzeln gekippt angeordnet sind.

In Fig. 2I und Fig. 2K sind die Spiegel 310 und 312 mit Rasterelementen 312 und 322 in Frontal- und Seitenansicht dargestellt. Die Außenform der Spiegel 310 und 312 ist an die Ausleuchtung mit dem Strahlenbüschel 360 angepaßt. Die Außenform der Rasterelemente 312 und 322 ist sechseckig gewählt. Die Rasterelemente 312 und 322 weisen den gleichen Krümmungsradius $R_0$ und damit die gleiche Brennweite auf. Die Ausdehnung D2 der Außenform der Rasterelemente 322 ist jedoch kleiner als die Ausdehnung D1 der Außenform der Rasterelemente 312. Da die Außenform der einzelnen Rasterelemente 312 und 322 die Ausleuchtung auf dem Spiegel 34 mit Feldwaben bestimmt, wird auch Spiegel 34 sechseckig ausgeleuchtet, jedoch je nach Ausdehnung D1 und D2 der Rasterelemente 312 und 322 unterschiedlich groß. Die Form des Sechseckes wurde gewählt, um die Rasterelemente 312 und 322 einerseits möglichst dicht zu packen, andererseits die Ausleuchtung des Spiegels 34 mit Feldwaben möglichst rund zu gestalten. Für eine runde Ausleuchtung wären runde Rasterelemente 312 und 322 ideal, diese können jedoch nicht nahtlos aneinandergereiht werden. Die Ausleuchtung des Spiegels 34 mit Feldwaben überträgt sich auch auf die Ausleuchtung der Austrittspupille 390. Die Ausleuchtung der Austrittspupille ist jedoch nicht mehr zusammenhängend, sondern auf Grund der Facettierung des Spiegels 34 mit Feldwaben diskretisiert. Die Außenform der Ausleuchtung bleibt jedoch sechseckig. Durch eine Maskierungseinrichtung in der Blendenebene kann die sechseckige Außenform der Ausleuchtung kreisrund beschnitten werden.

Je nach Struktur auf dem Retikel 39 kann die Ausleuchtung der Austrittspupille durch Tausch des Spiegels 310 mit Rasterelementen angepaßt werden. Neben einer nahezu runden Ausleuchtung unterschiedlicher Größe ist es für spezielle Retikelstrukturen günstig, das Retikel aus vier verschiedenen Richtungen zu beleuchten. Diese sogenannte Quadrupolbeleuchtung führt in der Austrittspupille 390 zu vier voneinander getrennten ausgeleuchteten Bereichen, wobei die ausgeleuchteten Bereiche auf Grund der Facettierung des Spiegels 34 mit Feldwaben diskretisiert ausgeleuchtet sind. Eine Quadrupol-Beleuchtung kann mit einem Spiegel 330 mit Rasterelementen 332, 334, 336 und 338 erreicht werden, wie er in Fig. 2M und Fig. 2N dargestellt ist. Die Funktionsweise des Spiegels 330 wird anhand Fig. 2M erläutert. Fig. 2M zeigt vier einzelne Rasterelemente 332, 334, 336 und 338, die jeweils außeraxiale Segmente einer konkaven oder konvexen Fläche enthalten. Ein zusammenhängendes Rasterelement mit einer quadratischen Umrandungslinie 331 und mit einer rotationssymmetrischen optischen Wirkung, die als gestrichelte Linien 333 dargestellt ist, würde den Spiegel 34 mit Feldwaben quadratisch ausleuchten. Benutzt man von diesem quadratischen Rasterelement nur die vier außeraxialen trapezförmigen Segmente 332, 334, 336 und 338, so wird der Spiegel 34 mit Feldwaben mit vier Trapezen ausgeleuchtet. Die trapezförmigen Rasterelemente 332,334, 336 und 338 können beliebig auf dem Spiegel 330 angeordnet werden. Die Trapezform bietet sich an, da sich dann die Rasterelemente auf dem Spiegel 330 dicht packen lassen, wie in Fig. 2N dargestellt. Dabei ist es erforderlich, die Rasterelemente der Form 334 und 338 entlang einer zwischen den schrägen Flanken liegenden Geraden zu teilen und diese geteilten Rasterelemente zusammen mit den ungeteilten Rasterelementen zu einer flächendeckenden Anordnung zusammenzusetzen. Selbstverständlich sind neben den trapezförmigen Rasterelementen auch rechteckige Rasterelemente denkbar.

Durch die Anordnung in einem Zickzack-Strahlengang kann es zur Verringerung der Dezentrierungsfehler günstig sein, neben einer anamorphotischen Wirkung der Rasterelemente auch die Außenform zu verzeichnen. Legt man ein x-y-Koordinatensystem in die Ebene des Spiegels 310, 320 und 330 mit Rasterelementen, und werden die Spiegel 310, 320 und 330 um die x-Achse gekippt, so muß die Außenform der Rasterelemente in der y-Richtung auseinandergezogen und der Krümmungsradius der Rasterelemente in x-Richtung betragsmäßig kleiner als in y-Richtung sein.

In Figur 20 ist ein Beleuchtungssystem mit Zwischenbild Z dargestellt. Das Zwischenbild Z befindet sich dabei in einer zur Objekt- bzw. Retikelebene konjugierten Ebene. Gleiche Bauteile wie in den Figuren 2C und 2D sind mit denselben Bezugsziffern belegt. Bei einem derartigen System kann, um die Beleuchtungsverteilung in der Austrittspupille des Beleuchtungssystems zu variieren, in diesem Zwischenbild Z oder defokussiert hierzu ein zusätzlicher Spiegel 200 plaziert werden.

Da sich die Retikelebene bei diesem System konjugiert zu dem zusätzlichen Spiegel 200 befindet, kann die Winkelverteilung in der Retikelebene durch Spiegel 200 beinflußt werden, während die Feldverteilung nahezu unbeeinflußt bleibt.

Zur Beeinflussung der Intensitätsverteilung in der Austrittspupille wird bei Systemen mit Zwischenbild Z nach dem Spiegel 34 mit Feldwaben beziehungsweise nach dem Spiegel mit Pupillenwaben am Ort des vorläufigen Zwischenbildes Z der zusätzliche Spiegel 200 vorgesehen. Der Ort des Spiegels 200 befindet sich in der Ebene, in der sich die Bilder der Feldwaben 34 des Spiegels mit Rasterelementen überlagern. Nach diesem zusätzlichen Spiegel 200 folgen ein oder zwei weitere zusätzliche Spiegel 202, die das Zwischenbild Z in die Retikelebene abbilden. Im dargestellten Beispiel ist dafür ein normal incidence Spiegel 202, vorgesehen.

Die auf den weiteren zusätzlichen Spiegel 202 folgenden Feldspiegel 36, 38 haben die Aufgabe der Ringfeldformung, der Abbildung der Austrittspupille des Beleuchtungssystems in die Eintrittspupille des nachfolgenden Objektives sowie die Steuerung der Beleuchtungsverteilung.

Der zusätzliche Spiegel 200 kann beispielsweise als zusätzlicher Spiegel mit Rasterelementen neben dem Spiegel mit Feldwaben 34 ausgeführt sein. Dabei sind die Rasterelemente des zusätzlichen Spiegels, sogenannte Einzelwaben, als sammelnde oder zerstreuende Spiegel oder entsprechende diffraktive Elemente ausgestaltet. Die Einzelwaben 201 können beispielsweise als Sechsecke in einer dichten Packung angeordnet sein. Eine derartige Anordnung ist in Figur 2 P gezeigt. Ein einfallendes Lichtbüschel wird durch die Vielzahl von Einzelwaben so umgewandelt, daß von jeder Einzelwabe 201 ein Lichtbüschel 203 vorgegebener Apertur ausgeht wie in Figur 2 Q gezeigt. Die Ausdehnung der Einzelwaben muß so klein wie möglich gewählt werden, um die Uniformitätsanforderungen in der Retikelebene erfüllen zu können. Eine typische Ausdehnung der Waben liegt bei 10 $\mu$m. Um in der Intensitätsverteilung der Retikelebene die Diskretisierung der Einzelwaben nicht zu sehen, ist es beispielsweise möglich, den zusätzlichen Spiegel mit Rasterelementen defokussiert zum Zwischenbild anzuordnen. Je nach Wirkung der Einzelwaben läßt sich die Ausleuchtung der Austrittspupille des Beleuchtungssystems variieren. Durch Tausch der Elemente kann der Füllgrad zwischen zum Beispiel $\sigma$ = 0,2 und $\sigma$ = 1,0 varriert werden.

Die in Fig. 21, Fig. 2K und Fig. 2N gezeigten Anordnungen von Rasterelementen können bei dem zusätzlichen Spiegel 200 mit Rasterelementen ebenfalls zum Einsatz kommen. Die Brennweiten der einzelnen Rasterelemente müssen dabei entsprechend angepaßt werden.

Alternativ kann der zusätzliche Spiegel 200 als deformierbarer Spiegel ausgeführt sein.

Generell kann man zwei Arten der Deformation einer Spiegeloberfläche in einer zur Retikelebene konjugierten Ebene unterscheiden:

- Statische Deformationen mit kleinen Ortsfrequenzen, die zu einer Veränderung der Schwerstrahlwinkelverteilung in der Retikelebene führen. Dieser Effekt kann beispielsweise zur Korrektur der Telezentrie herangezogen werden.

- Dynamische Deformationen mit sehr großen Ortsfrequenzen, die zu einer Variation der Aperturverteilung um den im Mittel konstanten Schwerstrahl führen und damit zu der gewünschten Beeinflussung der Ausleuchtung der Austrittpupille des Beleuchtungssystems führen. Derartige dynamische Deformationen zur Steuerung der Beleuchtungsverteilung müssen im Vergleich zur Belichtungszeit beziehungsweise Scangeschwindigkeit sehr schnell sein.

Die dynamischen Deformationen mit sehr großen Ortsfrequenzen lassen sich beispielsweise einsetzen, um die Beleuchtungsverteilung in der Austrittspupille des Beleuchtungssystems zu homogenisieren. Wie in den Figuren 7 bis 13 zu sehen, befinden sich zwischen den Bildern der sekundären Lichtquellen in der Austrittspupille unbeleuchtete Bereiche. Durch Vibrieren der Oberfläche des zusätzlichen deformierbaren Spiegels 200 lassen sich die im statischen Fall unbeleucheten Bereiche im zeitlichen Mittel betrachtet ebenfalls ausleuchten.

Zur gleichmäßigen Verteilung der sekundären Lichtquellen in der Blendenebene wurden die Facettenzeilen 40 mit den einzelnen Rasterelementen auf dem Spiegel 34 versetzt zueinander angeordnet, wie in Figur 3 gezeigt. Der Kreis 41 in Fig. 3 zeigt die Ausleuchtung des Spiegels mit Rasterelementen durch die EUV-Quelle 1. Das Aspektverhältnis der Rasterelemente 42 beträgt in dem dargestellten Fall 17,5:1.

Die Rasterelemente 42, die auch als Feldwaben nachfolgend bezeichnet werden, erzeugen in der Blendenebene des Beleuchtungssystems sekundäre Lichtquellen, deren Verteilung durch die Verteilung der Rasterelemente auf dem Spiegel vorgegeben ist.

Die sich in der Blendenebene ergebende Verteilung sekundärer Lichtquellen 44, bei Verwendung eines Spiegels mit Rasterelementen gemäß Figur 3, ist in Figur 4A gezeigt.

Die schattierte Fläche 46 in der Blendenebene gibt die maximale Blendenausleuchtung an, die von einem dem Beleuchtungssystem nachgeordneten Objektiv, dessen Eintrittspupille in vorliegendem Fall mit der Austrittspupille des Beleuchtungssystems zusammenfällt, aufgenommen werden kann.

Typischerweise beträgt die waferseitige Apertur eines EUV-Beleuchtungssystems $NA_{Wafer} = 0{,}1$. Dies entspricht bei einem Objektivabbildungsmaßstab von $\beta = -0{,}25$ in der Retikelebene einer Apertur von $NA_{Retikel} = 0{,}025$ bzw, bei dem vorliegend betrachteten System einem Durchmesser von 64 mm auf dem Spiegel mit Feldwaben.

Nachfolgend soll ein weiteres EUV-Beleuchtungssystem beispielhaft beschrieben werden.

Die für das nachfolgend beschriebene Design zugrundeliegende Wiggler-Quelle weist in horizontaler Richtung eine Apertur von 33 mrad, in vertikaler Richtung eine Apertur von 2 mrad auf. Die Länge der Quelle beträgt 2 m.

Das Beleuchtungssystem für diese Wiggler-Quelle geht von einer Doppelfacettierung, d.h. zwei Spiegeln mit Rasterelementen, aus, um zum einen die Quellstrahlung mit dem hohen Aspektverhältnis aufzunehmen und zum anderen die runde Pupille zu füllen. Ein derartiges System im prinzipiellen Aufbau ist in Figur 4D schematisch dargestellt. Die nachfolgend verwendeten Bezugsziffern beziehen sich hierauf.

Die Strahlung wird von einem grazing incidence Kollektorspiegel 30 aufgenommen und in ein nahezu paralleles Strahlenbüschel umgewandelt. Die darauf folgende Feld- 34 und Pupillenwabenplatten 37 werden als normal incidence Spiegel betrieben. Die Feldwaben werden so verteilt, daß sie die ausgeleuchtete rechteckige Fläche optimal abdecken. Jeder Feldwabe wird anschließend eine Pupillenwabe zugeordnet, die auf einem radialen Gitter in der Blende des Beleuchtungssystems angeordnet sind. Die Anordnung der Pupillenwaben wird so korrigiert, daß Aberrationen der Feldlinse 36, 38 vorgehalten werden. Durch Kipp von Feld- und Pupillenwaben werden die Bilder der Feldwaben in der Objekt- bzw. Retikelebene 39 überlagert. Mit den beiden grazing incidence Feldspiegeln 36, 38 wird das Beleuchtungssystem an ein nachfolgendes Projektionsobjektiv angepaßt.

Feld- 34 und Pupillenwabenplatte 37 bestehen in diesem System aus sammelnden Waben, die einzeln gekippt und im Falle der Feldwaben auch ein hohes Aspektverhältnis aufweisen.

Ausgelegt ist das Beleuchtungssystem für folgendes Feld in der Retikelebene:

- 60°-Segment mit r = 104 mm und $\Delta r = \pm\ 4{,}0$ mm $\rightarrow$ x-y-Aspektverhältnis von 108,9 mm/8mm = 13,6/1.
- Apertur in der Retikelebene $NA_{Ret} = 0{,}05$.
- Baulänge L zwischen Pupillenwabenplatte und Retikel: L = 1000 mm.
- Die Anzahl der Feldwaben wurde so gewählt, daß die Anforderungen an die Uniformität der Scan-Energie erfüllt werden können.

Die Kollektoreinheit 30 ist so ausgelegt, daß sie die Feldwabenplatte 34 der Größe A = 160 mm x 40 mm ausleuchtet. Die Ausleuchtung ist dabei durch die Wirkung des grazing incidence Kollektorspiegels 30 ringförmig, so daß nicht alle Feldwaben beleuchtet werden.

Die Form der Feldwaben wird rechteckig gewählt. Dabei entspricht das Aspektverhältnis der Feldwaben dem Verhältnis von Bogenlänge zu Ringbreite in der Retikelebene. Bei einer Wabengröße von 20 mm x 1,2 mm werden 120 Feldwaben beleuchtet, so daß sich eine ausreichende Homogenität der Scan-Energie ergibt. Die sammelnde Wirkung jeder Feldwabe ist so ausgelegt, daß sie in der Blendenebene eine sekundäre Lichtquelle erzeugt.

Am Ort der sekundären Lichtquellen befinden sich die Pupillenwaben auf der Pupillenwabenplatte 37, die die Feldwaben in die Retikelebene abbilden. Der Ort der Pupillenwaben in der Blendenebene wird unabhängig von der Rasterung der Feldwaben gewählt. Sie sind so angeordnet, daß sie in der Austrittspupille des Beleuchtungssystems eine vorgegebene Verteilung erzeugen. Beispielsweise sind die Pupillenwaben auf einem radialen Gitter angeordnet. Zum Vorhalt von Pupillenaberrationen der nachfolgenden Feldlinse 36, 38 können sie auch auf einem verzeichneten Gitter angeordnet sein.

Jeder Feldwabe wird eine Pupillenwabe zugeordnet. Die Zuordnung von Feldund Pupillenwaben kann nach verschiedenen Gesichtspunkten erfolgen. Eine Möglichkeit ist, jeweils die räumlich benachbarten Waben zuzuordnen.

Dadurch werden die Umlenkwinkel minimal. Eine andere Möglichkeit besteht darin, die Intensitätsverteilung in der Pupillenebene zu homogenisieren. Dies kommt dann zum Tragen, wenn die Intensitätsverteilung in der Ebene der Feldwaben einen Verlauf aufweist. Haben Feld- und Pupillenwaben ähnliche Positionen, überträgt sich der Verlauf auf die Pupillenausleuchtung. Durch gezielte Durchmischung der Zuordnung kann die Intensität ausgeglichen werden. Durch Kipp von Feld- und Pupillenwabe werden die Strahlbüschel so umgelenkt, daß die Bilder der Feldwaben in der Retikelebene überlagert werden.

Ohne Feldlinse 36, 38 wird in der Retikelebene ein Rechteckfeld ausgeleuchtet. Das ausgeleuchtete Ringsegment in der Retikelebene wird von den grazing incidence Feldspiegeln geformt. Sie bilden zudem die Blendenebene des Beleuchtungssystems in die Eintrittspupille des Objektivs ab und können den Verlauf der Scan-Energie steuern.

Zur Steuerung der Ausleuchtung der Austrittspupille des Beleuchtungssystems können eine Auswahl von Feld- oder Pupillenwaben maskiert werden bzw. unbeleuchtet bleiben. Denkbar ist auch, die Pupillenwaben bereits so anzuordnen, daß sich eine vorgegebene Ausleuchtung in der Austrittspupille ergibt. Beispielsweise wird durch die Anordnung der Pupillenwaben ein Ring in der Austrittspupille ausgeleuchtet. Durch Steuerung der Beleuchtung des Spiegels mit Feldwaben oder durch Maskierung des Spiegels mit Pupillenwaben kann ein Wechsel zu Quadrupolausleuchtung vorgenommen werden.

In den Fig. 4B-4M ist ein EUV-Beleuchtungssystem mit Wiggler-Quelle gezeigt. Gleiche Bauteile wie in Fig. 1-4A sind mit denselben Bezugsziffern belegt.

Fig. 4B zeigt eine schematische Darstellung des Kollektorspiegels 30 im y-z-Schnitt. Die Quelle befindet sich im Abstand von 1700 mm vor dem Kollektorspiegel.

Fig. 4C zeigt eine schematische Darstellung des Kollektorspiegel 30 im x-z-Schnitt.

In Fig. 4D ist das Beleuchtungssystem im y-z-Schnitt gezeigt. Die Quelle ist nicht eingezeichnet und befindet sich im Abstand von 1700 mm vor dem Kollektorspiegel 30.

Dargestellt sind der Kollektorspiegel 30, der erste Spiegel mit Rasterelementen, der auch als Feldwabenplatte 34 bezeichnet wird, der zweite Spiegel mit Rasterelementen, der auch als Pupillenwabenplatte 37 bezeichnet wird, die Feldlinsen 36, 38 sowie die Retikelebene 39.

Fig. 4E zeigt eine schematische Darstellung der Feldwabenplatte 34. Eingezeichnet ist auch die bogenförmige Ausleuchtung. Zur besseren Darstellung sind alle Waben bzw. Rasterelemente 42 in x-y-Richtung ausgerichtet. Im realen System sind die Waben 42 durch Verkippung um ihre x- und y-Achse um ihre eigene z-Achse gedreht.

Fig. 4F zeigt eine schematische Darstellung der Pupillenwabenplatte 37. Die Pupillenwaben 43 sind auf Speichen angeordnet.

In Fig. 4G sind die Aufpunkte der Feldwaben 42, wie sie im ausgeführten Beispiel angeordnet sind, dargestellt.

Fig. 4H zeigt die Aufpunkte der Pupillenwaben 43, wie sie sich ohne Feldlinse 36, 38 ergeben würden und Fig. 4I die Aufpunkte der Pupillenwaben 43, wie sie sich mit Feldlinse 36, 38 ergeben. Die verzeichnete Anordnung der Pupillenwaben 43 kompensiert die Pupillenaberrationen der Feldlinse 36, 38.

Fig. 4K zeigt die Ausleuchtung der Retikelebene 39 mit dem Ringfeld bei dem in Fig. 4B-4I gezeigten System.

In Fig. 4L sind Intensitätsschnitte in der Retikelebene 39 bei x = 0,0 mm, 15,0 mm, 30,0 mm, 45,0 mm dargestellt.

Fig. 4M zeigt den Verlauf der Scan-Energie, die sich als Integral über die Intensitätsverteilung entlang des Scan-Weges ergibt.

Die Lichtverteilung bzw. das Beleuchtungssetting in der Austrittspupille, die vorliegend mit der Eintrittspupille des Projektionsobjektives zusammenfällt, wird bei kreisförmiger Ausleuchtung durch den Füllfaktor σ definiert. Es gilt: Füllfaktor:

$$\sigma = \frac{r_{Beleuchtung}}{R_{Objektivapertur}}$$

Die Parameter $r_{Beleuchtung}$ und $R_{Objektivapertur}$ sind aus Figur 5 entnehmbar.
Der Parameter $R_{Objektivapertur}$ gibt den Durchmesser der Eintrittspupille bei maximaler Objektivapertur an. Der Parameter $r_{Beleuchtung}$ gibt den Durchmesser der kreisförmigen Ausleuchtung der Eintrittspupille an. Bei sechseckiger oder nicht zusammenhängender Ausleuchtung der Eintrittspupille kann $r_{Beleuchtung}$ auch über eine radiale Integration über der gesamten ausgeleuchteten Fläche in der Eintrittspupille bestimmt werden. Dann entspricht der Füllgrad σ dem im folgenden bei der annularen Beleuchtung definierten Kohärenzfaktor $\sigma_{out}$.

Definitionsgemäß ist für σ = 1,0 die Eintrittspupille des Projektionsobjektives vollständig gefüllt; und beispielsweise σ = 0,6 entspricht einer Unterfüllung.

Bei einer annularen Lichtverteilung ist die Eintrittspupille des Projektionsobjektives ringförmig ausgeleuchtet. Zu ihrer Beschreibung kann man folgende Definition von $\sigma_{out}/\sigma_{in}$ verwendet:

$$\sigma_{out} = \frac{r(90)}{R(NA_{max})} \quad wobei \int_0^{r(90)} I(r)\,rdr = 0,9 \cdot \int_0^{R(NA_{max})} I(r)\,rdr$$

$$\sigma_{in} = \frac{r(10)}{R(NA_{max})} \quad wobei \int_0^{r(10)} I(r)\,rdr = 0,1 \cdot \int_0^{R(NA_{max})} I(r)\,rdr$$

wobei:

| | |
|---|---|
| I(r) = I (x, y) : | Intensitätsverteilung in der Eintrittspupille des Projektionsobjektivs |
| x, y : | x, y-Ort in der Eintrittspupille des Projektionsobjektivs |
| r : | radialer Ort in der Eintrittspupille des Projektionsobjektivs |
| $NA_{max}$ : | maximale Objektivapertur |
| R ($NA_{max}$) : | radialer Rand der Eintrittspupille bei maximaler Objektivapertur |
| r(90) : | Radius eines Kreises innerhalb dessen 90 % der Gesamtintensität auftreten |
| r(10) : | Radius eines Kreises innerhalb dessen 10 % der Gesamtintensität auftreffen |
| $\sigma_{out}$, $\sigma_{in}$ : | Kohärenzfaktor |

Eine weitere im nachfolgenden untersuchte Lichtverteilung ist die sogenannte Quadrupol-Beleuchtung zur Abbildung von beispielsweise "Manhattan-Strukturen".

Wie die Figuren 6A bis 6D zeigen, kann durch gezielte Ausleuchtung 41 der Feldwabenplatte die Anzahl der sekundären Lichtquellen 44 und damit die Blendenausleuchtung variiert werden. Die Figuren 6A bis 6D zeigen die Ausleuchtung der Feldwabenplatte mit Rasterelementen 40 und die zugehörige Verteilung der sekundären Lichtquellen 44 in der Austrittspupille 49 des Beleuchtungssystems, die zugleich Eintrittspupille des nachgeschalteten Objektives ist. Gleiche Bauteile, wie in den Fig. 3-5 werden in den Fig. 6A-6D mit denselben Bezugsziffern belegt.

Die Ausleuchtung der Feldwabenplatte kann dabei über eine vor der Feldwabenplatte angeordnete Maskierungseinrichtung, den ansteuerbaren Scan-Spiegel, den austauschbaren Kollektorspiegel, den deformierbaren Kollektorspiegel oder den austauschbaren zusätzlichen Spiegel mit Rasterelementen gezielt verändert werden.

Figur 6A zeigt die Ausleuchtung für einen Füllgrad $\sigma$ = 1,0. In Figur 6B ist eine kreisförmige Ausleuchtung mit einem Füllgrad von $\sigma$ = 0,6 dargestellt. Figur 6C zeigt ein annulares bzw. ringförmiges Setting mit

$$\frac{\sigma_{out}}{\sigma_{in}} = \frac{1,0}{0,7}$$

In Figur 6D ist eine Quadrupol-Beleuchtung der Feldwabenplatte dargestellt.

In den Figuren 7 bis 18 sind die Ergebnisse von Simulationsrechnungen für die in den Figuren 6A-6D gezeigten verschiedenen Beleuchtungsverteilungen dargestellt.

Folgende Settings bzw. Verteilungen werden beispielhaft beschrieben:

1. kreisförmiges Setting mit $\sigma$ = 1,0
Ausleuchtung der Feldwabenplatte mit einem Radius von r = 35,0 mm, was einer Apertur von $NA_{Ret}$ = 0,025 entspricht.

2. kreisförmiges Setting mit $\sigma$ = 0,6 kreisförmige Ausleuchtung der Feldwabenplatte mit Radius r = 20,0 mm.

3. annulares Setting mit

$$\frac{\sigma_{out}}{\sigma_{in}} = \frac{1,0}{0,7}$$

ringförmige Ausleuchtung der Feldwabenplatte mit Radius $r_{out}$ = 35,0 mm und $r_{in}$ = 25 mm.

4. Quadrupol-Setting
vier kreisförmige Ausleuchtungen der Feldwabenplatte mit r = 10 mm auf den Diagonalen und mit einem Abstand a = 21,2 mm von der optischen Achse.

Die sich ergebende Pupillenausleuchtung bei Beleuchtung der Feldwabenplatte gemäß 1.- 4. wird für den Achspunkt (x = 0,0; y = 0,0) und einen Feldpunkt bei (x = 40,0; y = 4,041) am Rand berechnet und in den Figuren 7-14 dargestellt.

Für den Fall eines Füllgrades σ = 1,0 (Fall 1) ist die Pupille bis zur Maximal-Apertur von $NA_{Ret}$ = 0,025 mit 213 sekundären Lichtquellen gleichmäßig gefüllt. In Figur 7 ist die Pupillenausleuchtung für den Feldpunkt in der Mitte der Retikelebene x = 0, y = 0 dargestellt.

Wie aus Figur 8 für den Punkt am Feldrand x = 40,0, y = 4,041 hervorgeht, bleibt die Form der Pupillausleuchtung auch am Feldrand erhalten. Die Pupille gemäß Figur 8 ist insgesamt aber um den Offset des Schwerstrahlwinkels verschoben, wobei die optische Achse des Beleuchtungssystems in der Retikelebene das Bezugssystem darstellt.

Für einen Füllgrad von σ = 0,6 (Fall 2) ist die Pupille bis zur Apertur von $NA_{Ret}$ = 0,6 · 0 · 0,025 = 0,015 mit 72 sekundären Lichtquellen gefüllt. Die Pupillenausleuchtung für den Feldpunkt in der Mitte der Retikelebene (x = 0, y = 0) ist in Figur 9 gezeigt; die für den Feldpunkt am Rand (x = 40,0, y = 4,041) in Figur 10.

Für ein ringförmiges Setting (Fall 3) mit

$$\frac{\sigma_{out}}{\sigma_{in}} = \frac{1,0}{0,7}$$

ist die Pupille zwischen der Apertur $NA_{out}$ = 0,025 und $NA_{in}$ = 0,0175 mit 102 sekundären Lichtquellen gefüllt. Die Ausleuchtung für den Feldpunkt in der Mitte der Retikelebene (x = 0, y = 0) ist in Figur 11 gezeigt; die für den Punkt am Feldrand (x = 40,0, y = 4,041) in Figur 12.

Bei Ausleuchtung der Wabenplatte mit einer Quadrupol-Beleuchtung (Fall 4) wird die Austrittspupille in den vier Segmenten mit jeweils 18 sekundären Lichtquellen gefüllt. Figur 13 zeigt die Ausleuchtung für einen Punkt in der Feldmitte, Figur 14 für einen Punkt am Feldrand.

Die Auswertung der Uniformität der Scan-Energie für die unterschiedlichen Beleuchtungssettings ist in den Figuren 15 bis 18 dargestellt. Es zeigt sich eine Abhängigkeit von der Beleuchtung der Wabenplatte, d.h. vom Setting.

Für einen Füllgrad σ = 1,0 bei kreisförmiger Ausleuchtung zeigt sich ein idealer Verlauf der Scan-Energie mit Uniformitäts-Einbußen < 1 %, wie aus Fig. 15 zu sehen.

Für einen Füllgrad σ = 0,6 bei kreisförmiger Ausleuchtung zeigen sich durch die Verringerung der Anzahl der am Mischprozeß beteiligten Feldwaben Uniformitäts-Einbußen von 2 % wie aus Figur 16 hervorgeht. Die Anzahl der Feldwaben betrug in dem vorangegangenen Beispiel für Füllgrad σ = 1,0 213 Feldwaben, wohingegen bei σ = 0,6 nur 72 Feldwaben ausgeleuchtet werden und damit am Mischprozeß beteiligt sind.

Bei annularer Beleuchtung werden viele Feldwaben nur teilweise beleuchtet. Das hat zur Folge, daß bei Beteiligung von 102 Feldwaben gegenüber 213 Feldwaben bei σ=1,0 am Mischprozeß die Uniformitäts-Einbuße 3 %, wie in Figur 17 gezeigt, beträgt. Die größere Uniformitäts-Einbuße bei annularer Beleuchtung gegenüber kreisförmiger Beleuchtung mit σ = 0,6 trotz der Beteiligung von mehr Feldwaben am Mischprozeß ist auf die nur teilweise Beleuchtung der Feldwaben zurückzuführen.

Bei Quadrupol-Beleuchtung zeigt die Scan-Energie eine charakteristische "4-Welligkeit" mit einer Uniformität von 5 %, wie aus Figur 18 hervorgeht. Diese kommt dadurch zustande, daß je nach Feldpunkt bei Quadrupol-Beleuchtung zusätzliche Feldwaben zur Beleuchtung beitragen können oder wegfallen und fast alle Feldwaben nur teilweise ausgeleuchtet sind.

Wie aus der beschriebenen Simulation hervorgeht, wird die variable Pupillenausleuchtung durch die geforderte Uniformität der Intensitätsverteilung bei Stepper-Systemen bzw. Uniformität der Scan-Energie bei Scanner-Systemen limitiert. Allgemein gilt, daß je weniger Wabenbilder in der Retikelebene überlagert werden, desto schlechter die Durchmischung und somit die Uniformität der Feldausleuchtung ist. Möchte man für extreme Pupillenverteilungen, d.h. kleines σ bei kreisförmiger Ausleuchtung oder schmaler Ring bei annularer Ausleuchtung oder Quadrupol, die Uniformität steigern, so muß die Anzahl der Waben erhöht werden, was bei gleichbleibenden Abmessungen der Feldwabenplatte eine Verringerung der Wabenabmessungen und eine Erhöhung des Wabenabbildungsmaßstabes bedeutet.

Aufgrund des hohen Aspektverhältnisses von 17,5:1 der Waben in vorliegenden Ausführungsbeispielen werden die Waben am Rand der beleuchteten Fläche nur teilweise ausgeleuchtet. Figur 19 zeigt eine Konfiguration, bei der in jeder x-Zeile 98 nur zwei Feldwaben 100,102 ausgeleuchtet werden. Jede Wabe 100,102, die beleuchtet wird, erzeugt in der Blendenebene des Beleuchtungssystems eine sekundäre Lichtquelle 104, wie in Figur 20 dargestellt.

Die Verteilung der sekundären Lichtquellen 104 in der Blendenebene bei kreisrunder Beleuchtung der Feldwabenplatte ist folglich elliptisch, da in x-Richtung weitere sekundäre Lichtquellen hinzukommen. Die Pupillenausleuchtung jedes einzelnen Feldpunktes in der Retikelebene bleibt jedoch kreisrund, da nicht jeder Feldpunkt Licht von jeder sekundären Lichtquelle bekommt. Anschaulich gesprochen wird die Pupillenverteilung für den Feldrand rechts- bzw. linkslastig, wie in Figur 20 dargestellt.

Mit einer speziell geformten Maskierungseinrichtung kann erreicht werden, daß alle unvollständig ausgeleuchteten Feldwaben 102 abgedeckt werden. Diese Maskierungseinrichtung ist unmittelbar vor dem Spiegel 98 mit Feldwaben 102 anzuordnen. Die Umrandungslinie der Maskierungseinrichtung ist dabei an die Außenform der Feldwaben 102 angepaßt. Für verschiedene Ausleuchtungen des Spiegels 98 mit Feldwaben 102 müssen entsprechend angepaßte Maskierungseinrichtungen zum Einsatz kommen, die beispielsweise ausgetauscht werden.

Zur Reduzierung des Aspektverhältnisses können die einzelnen Waben so ausgebildet werden, daß sie eine anamorphotische Wirkung aufweisen, wie beispielsweise in der DE 199 31 848.4, eingereicht am 09.07.1999, für die Anmelderin beschrieben, deren Offenbarungsgehalt in die vorliegende Anmeldung vollumfänglich mit aufgenommen wird.

In Fig. 21 und 22 sind zwei Feldwabenplatten 34 mit gleicher Anzahl Feldwaben 42 dargestellt, wobei jedoch das Aspektverhältnis bzw. die Größe der Feldwaben 42 unterschiedlich ist. Das Aspektverhältnis der Waben 42.1 in Fig. 21 beträgt 17,5 : 1; das der Waben 42.2 in Fig. 22 1:1, Wie aus dem Vergleich von Fig. 21 und Fig. 22 zu entnehmen, sind bei gleich großer Ausleuchtung 41 der Wabenplatten in Fig. 21 und Fig. 22 im Fall der quadratischen Waben 42.2 mehr Waben vollständig ausgeleuchtet als im Fall der Waben 42.1 mit hohem Aspektverhältnis. Dadurch ist die Uniformität der Ausleuchtung im Fall der quadratischen Waben besser als im Fall einer Wabenplatte mit Waben mit hohem Aspektverhältnis. Bei Feldwaben mit reduziertem Aspektverhältnis ist deshalb bei gleicher geforderter Uniformität eine geringere Anzahl von Feldwaben nötig.

## Patentansprüche

**1.** Beleuchtungssystem für eine Projektionsbelichtungsanlage, umfassend

   1.1 eine Lichtquelle (1) zur Emission von Wellenlängen < 193 nm;
   1.2 einer Objekt- bzw. Retikelebene (39);
   1.3 einer zur Objektebene (39) konjugierten Ebene (Z) zwischen Lichtquelle (1) und Objektebene (39);
   1.4 Mittel zum Erzeugen sekundärer Lichtquellen, die zwischen der Lichtquelle (1) und der konjugierten Objektebene (Z) angeordnet sind, wobei die Mittel mindestens eine Spiegel- oder Linsenvorrichtung, umfassend mindestens einen Spiegel oder eine Linse (34), der bzw. die in Rasterelemente (10, 40, 100, 102) gegliedert ist, aufweisen, **dadurch gekennzeichnet, daß**
   1.5 am Ort oder nahe am Ort der konjugierten Objektebene (Z) Einrichtungen (200) zum Erzeugen einer vorbestimmten Lichtverteilung in der Austrittspupille (390) des Beleuchtungssystems angeordnet sind.

**2.** Beleuchtungssystem nach Anspruch 2, **dadurch gekennzeichnet, daß** das Beleuchtungssystem eines oder mehrere erste optische Elemente (36, 38) umfaßt, das bzw. die die von den Rasterelementen erzeugten sekundären Lichtquellen in die Austrittspupille (39) des Beleuchtungssystems abbilden bzw. abbildet.

**3.** Beleuchtungssystem nach einem der Ansprüche 1 bis 2, **dadurch gekennzeichnet, daß** die Mittel zur Erzeugung einer vorbestimmten Ausleuchtung Spiegel mit deformierbarer Oberfläche umfassen.

**4.** Beleuchtungssystem nach Anspruch 3, **dadurch gekennzeichnet, daß** die Spiegel mit deformierbarer Oberfläche eine Vielzahl von Manipulatoren umfaßt.

**5.** Beleuchtungssystem nach Anspruch 4, **dadurch gekennzeichnet, daß** die Manipulatoren an der Spiegelunterseite angeordnet sind.

**6.** Beleuchtungssystem nach Anspruch 4 oder 5, **dadurch gekennzeichnet, daß** die Manipulatoren Piezoelemente und/oder Elemente für eine elektromagnetische Anregung zur Erzeugung der Deformation umfassen, wobei die Piezoelemente und/oder Elemente für die elektromagnetische Anregung ansteuerbar sind.

**7.** Beleuchtungssystem nach einem der Ansprüche 3 bis 6, **dadurch gekennzeichnet, daß** die deformierbare Oberfläche derart angesteuert wird, daß dynamische Deformationen mit großer Ortsfrequenz hervorgerufen werden.

**8.** Beleuchtungssystem nach Anspruch 7, **dadurch gekennzeichnet, daß** die dynamischen Deformationen großer Ortsfrequenz derart gewählt werden, daß die diskreten Bilder der sekundären Lichtquellen in der Austrittspupille so verschoben werden, daß sie die Austrittspupille im zeitlichen Mittel weitgehend füllen.

**9.** Beleuchtungssystem nach Anspruch 1, **dadurch gekennzeichnet, daß** die Mittel zur Erzeugung der Lichtverteilung einen zusätzlichen Spiegel mit Rasterelementen umfassen.

**10.** Beleuchtungssystem nach Anspruch 9, **dadurch gekennzeichnet, daß** die Rasterelemente des zusätzlichen Spiegels sammelnd oder zerstreuend ausgebildet sind.

**11.** Beleuchtungssystem nach Anspruch 9 oder 10, **dadurch gekennzeichnet, daß** die Rasterelemente des zusätzlichen Spiegels diffraktiv ausgebildet sind.

**12.** Beleuchtungssystem nach einem der Ansprüche 9 bis 11, **dadurch gekennzeichnet, daß** der zusätzliche Spiegel mit Rasterelementen austauschbar ist.

**13.** Beleuchtungssystem nach einem der Ansprüche 1 bis 12, **dadurch gekennzeichnet, daß** die Art der Lichtverteilung in der Austrittspupille eine Kreisverteilung ist oder zumindest der Kreisverteilung nahe kommt.

**14.** Beleuchtungssystem nach Anspruch 13 **dadurch gekennzeichnet, daß** der Füllgrad G der kreisförmig oder nahezu kreisförmig ausgeleuchteten Austrittpupille kleiner 1.0, insbesondere kleiner 0.6 ist.

**15.** Beleuchtungssystem nach einem der Ansprüche 1 bis 12, **dadurch gekennzeichnet, daß** die Art der Lichtverteilung in der Austrittspupille eine Ringverteilung ist.

**16.** Beleuchtungssystem nach einem der Ansprüche 1 bis 12, **dadurch gekennzeichnet, daß** die Art der Lichtverteilung in der Austrittpupille eine Quadrupolverteilung ist.

**17.** EUV-Projektionsbelichtungsanlage der Mikrolithographie mit einem Beleuchtungssystem nach einem der Ansprüche 1 bis 16 einer Maske, einem Projektionsobjektiv sowie einem lichtempfindlichen Objekt, insbesondere einem Wafer auf einem Trägersystem.

**18.** EUV-Projektionsbelichtungsanlage der Mikrolithographie nach Anspruch 17, ausgeführt als Scanning-System.

**19.** Verfahren zur Herstellung mirkoelektronischer Bauelemente, insbesondere Halbleiterchips mit einer EUV-Projektionsbelichtungsanlage nach einem der Ansprüche 17 bis 18.

Fig.1a

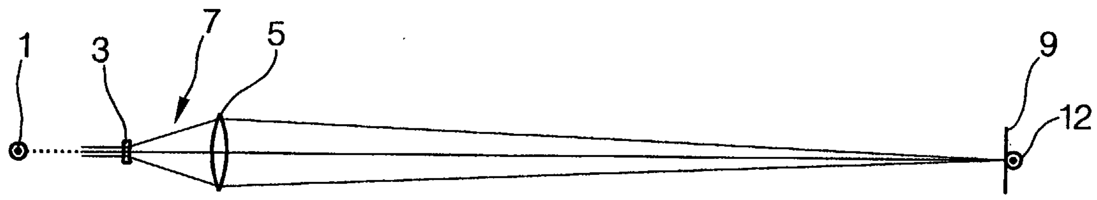


Fig.1b

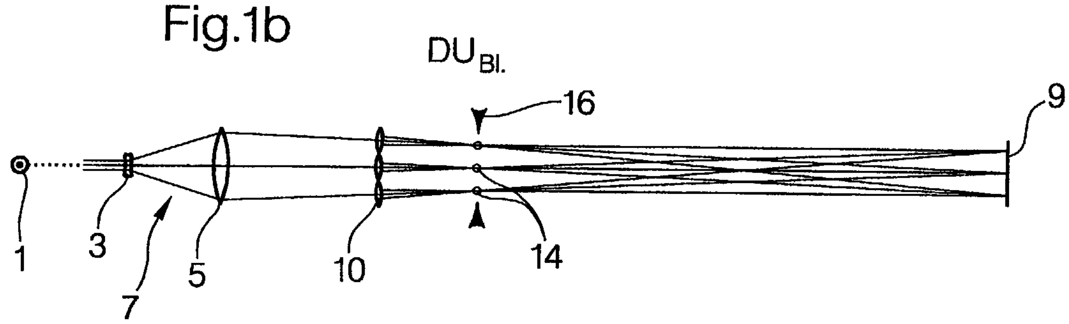


Fig.2a

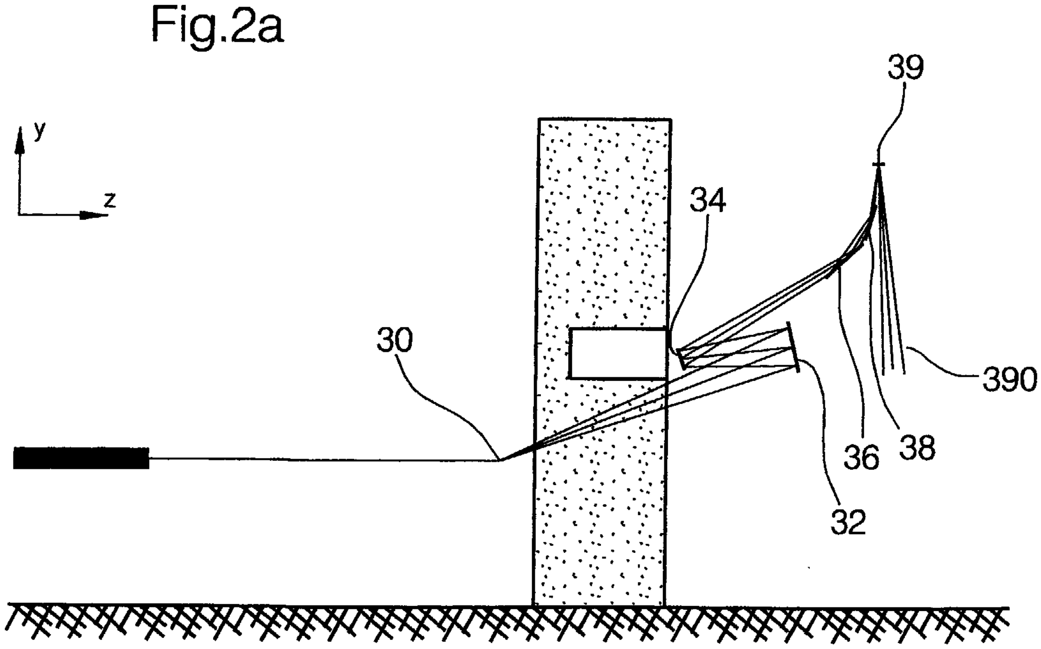

Fig.2b

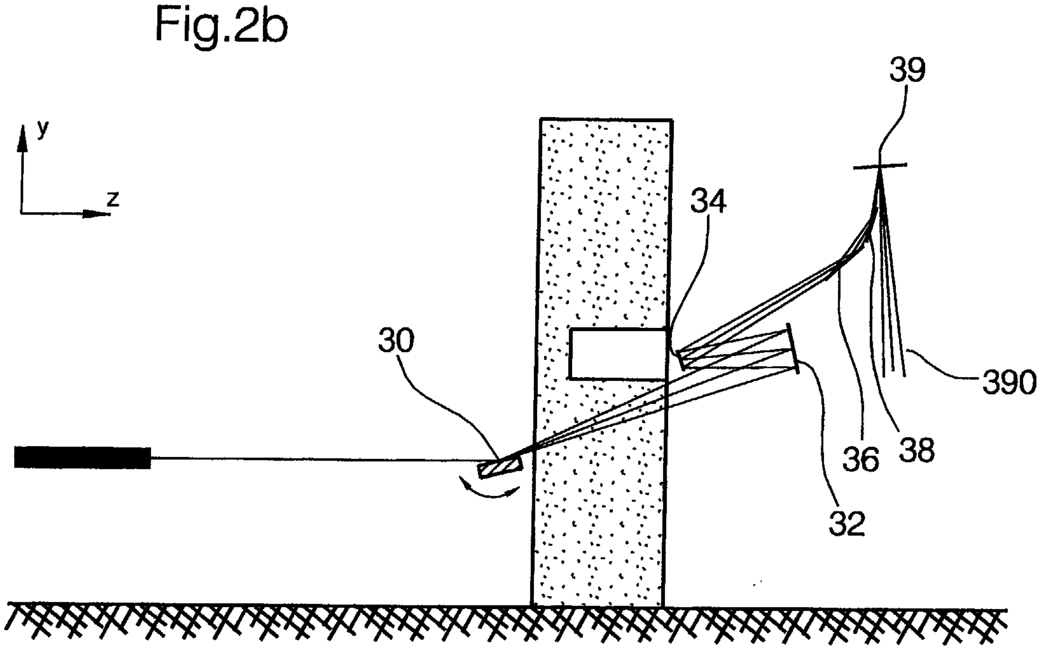

Fig.2c

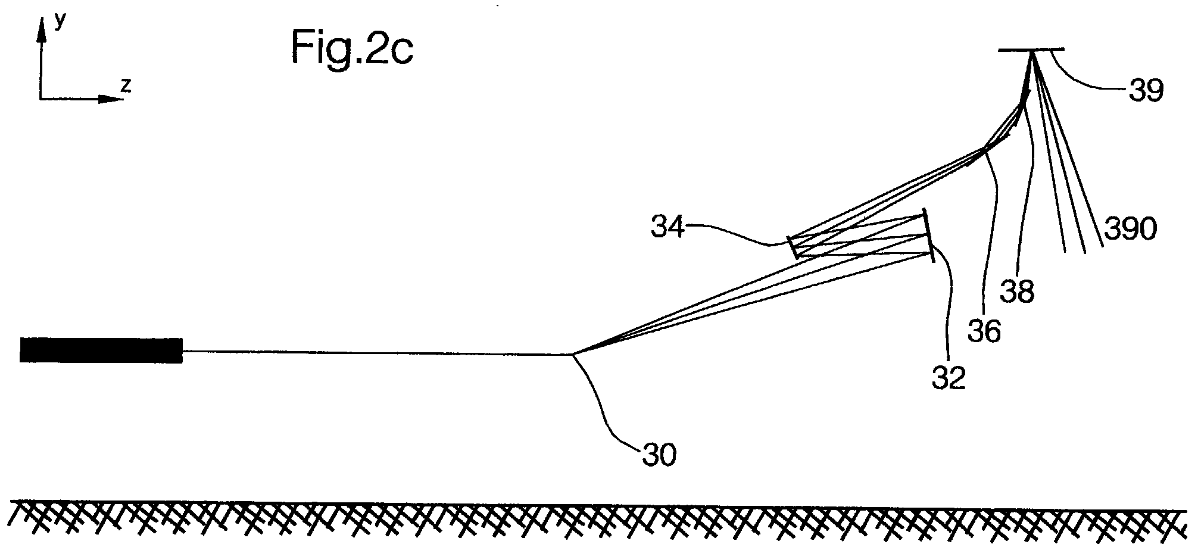


Fig.2d

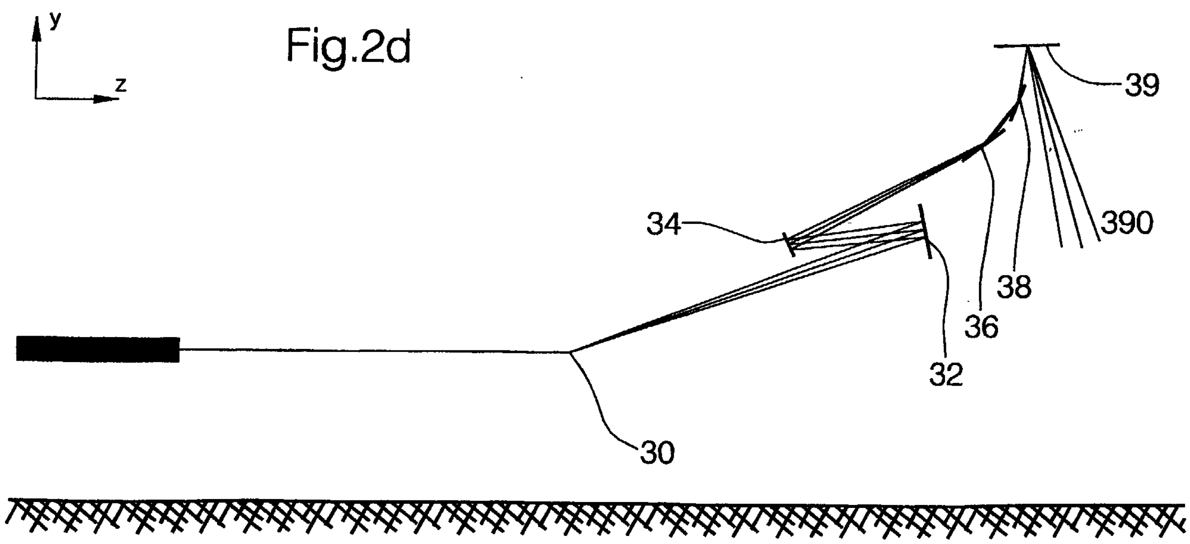

Fig.2e

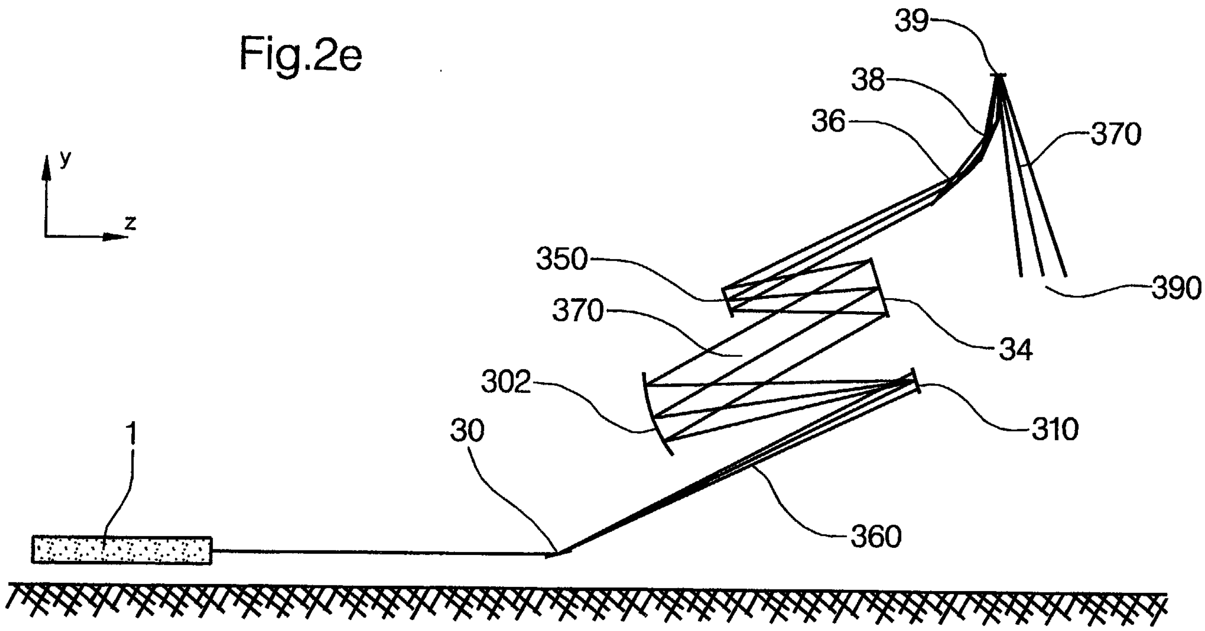
39
38
36
370
y
z
350
390
370
34
302
310
1
30
360

Fig.2f

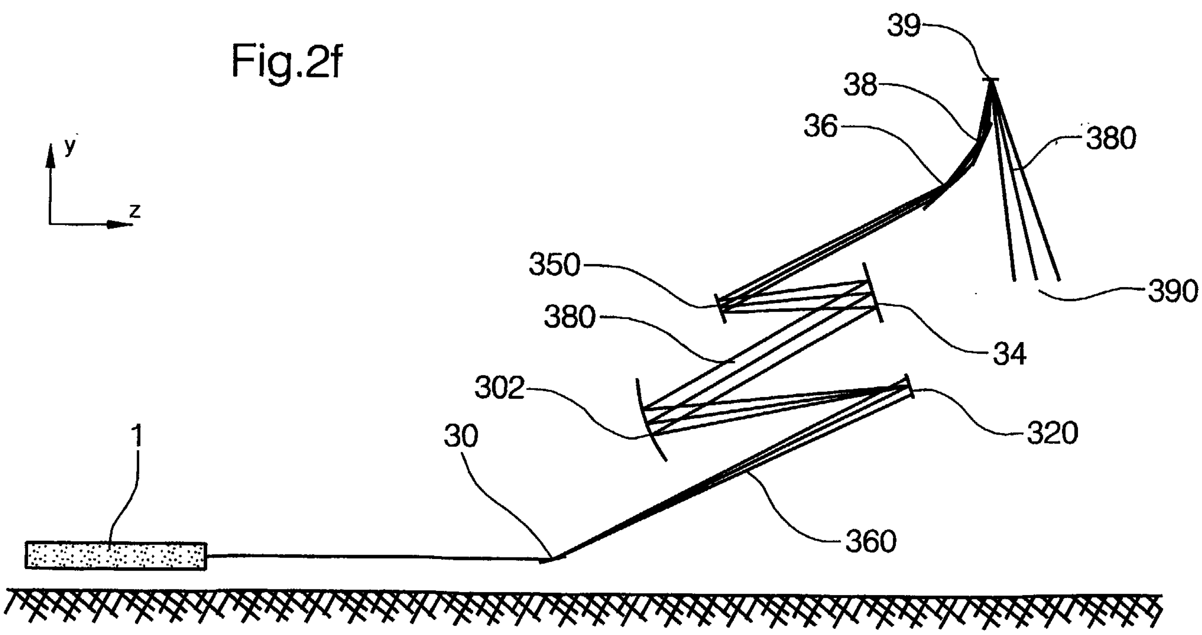
39
38
36
380
y
z
350
390
380
34
302
320
1
30
360

Fig.2g

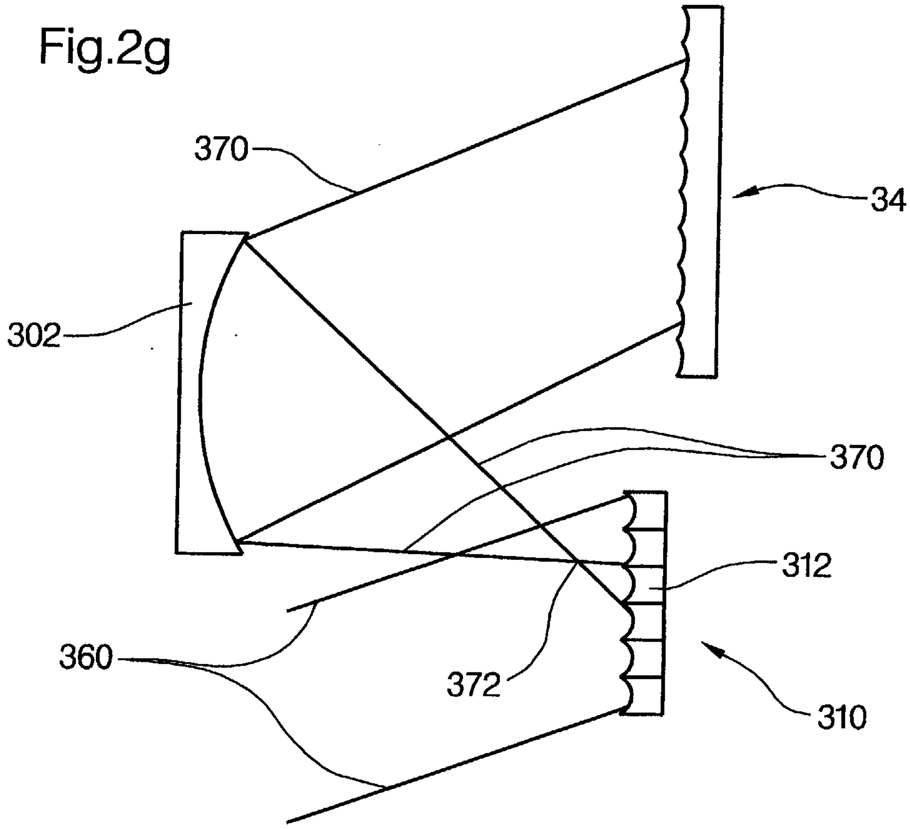


Fig.2h

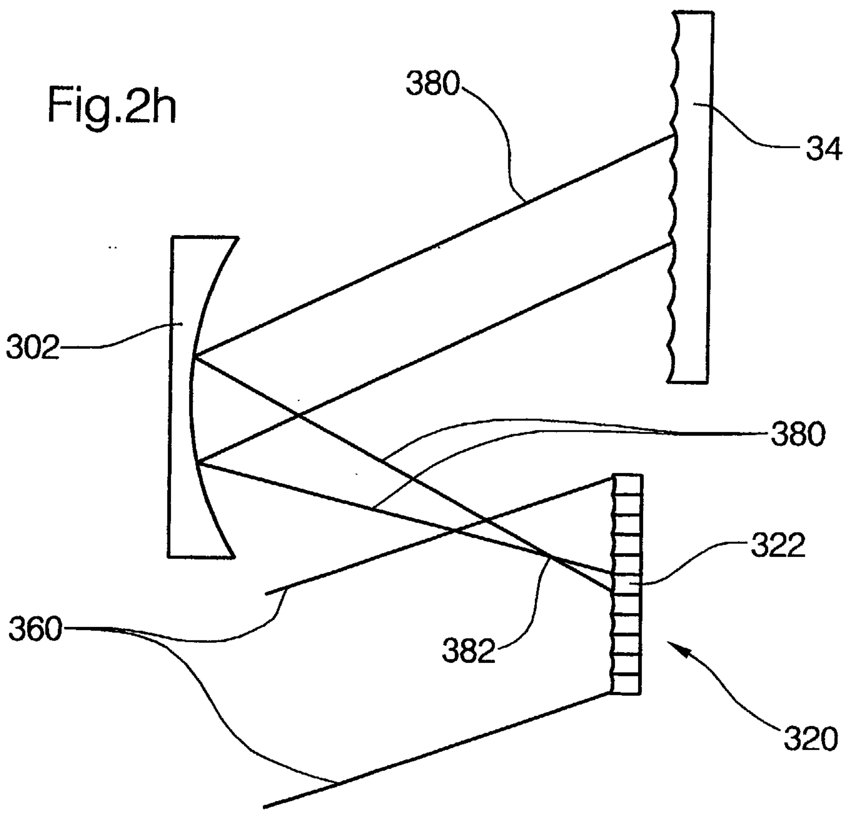

Fig.2i

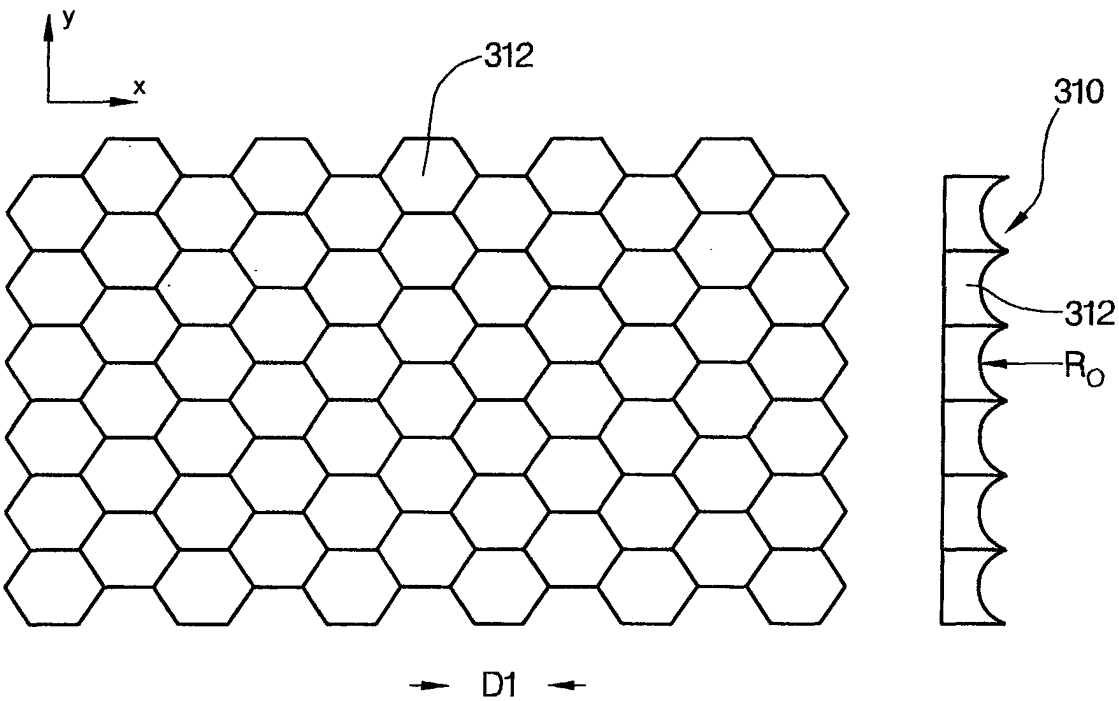


Fig.2k

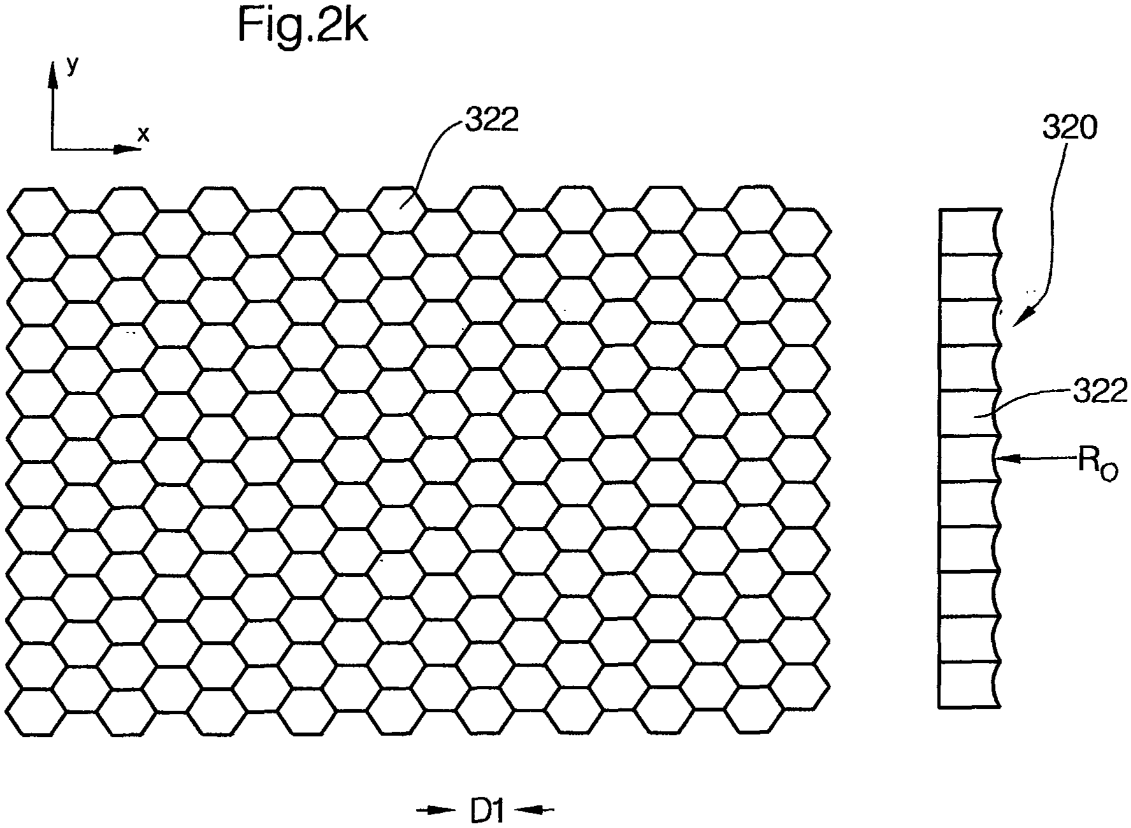

Fig.2m

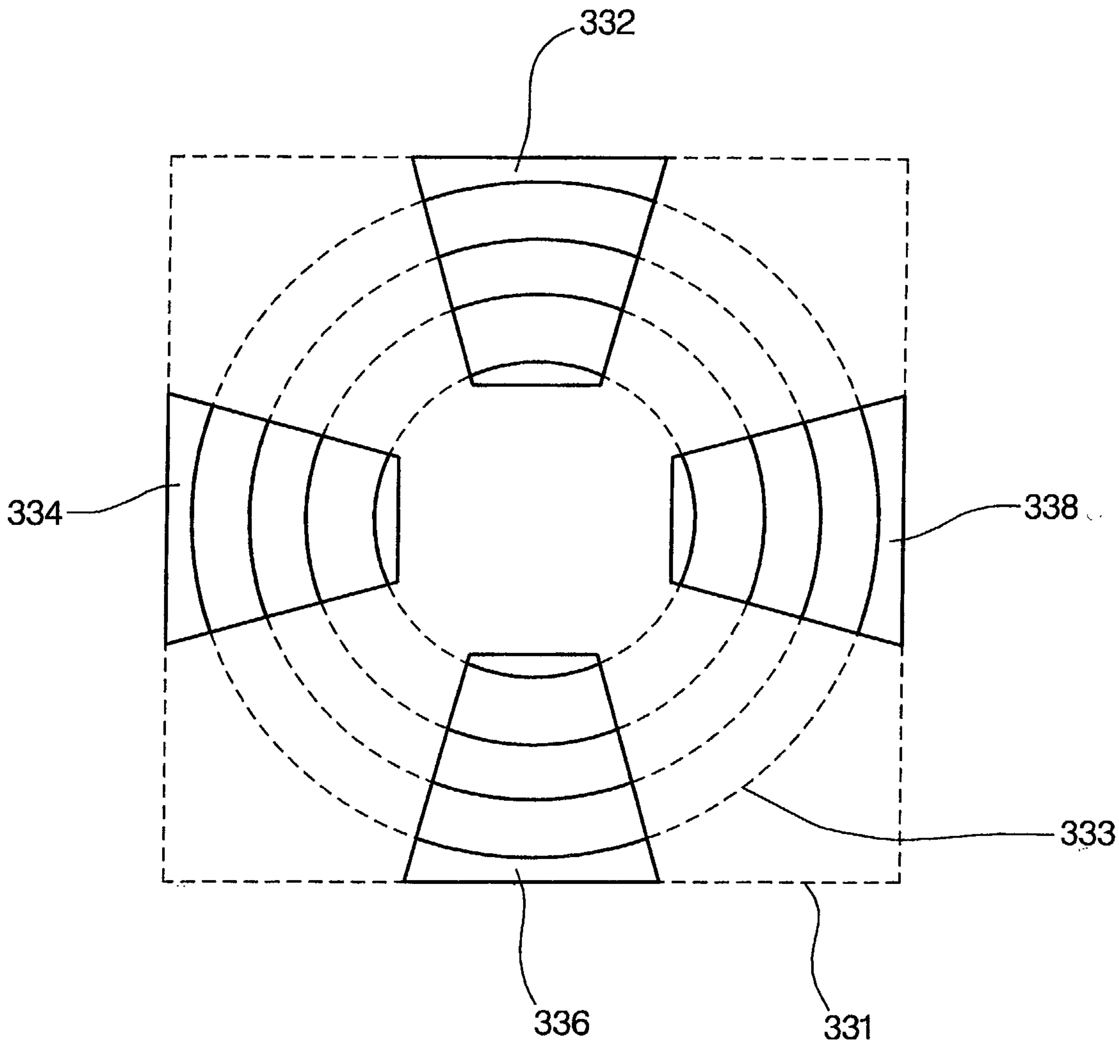

Fig.2n

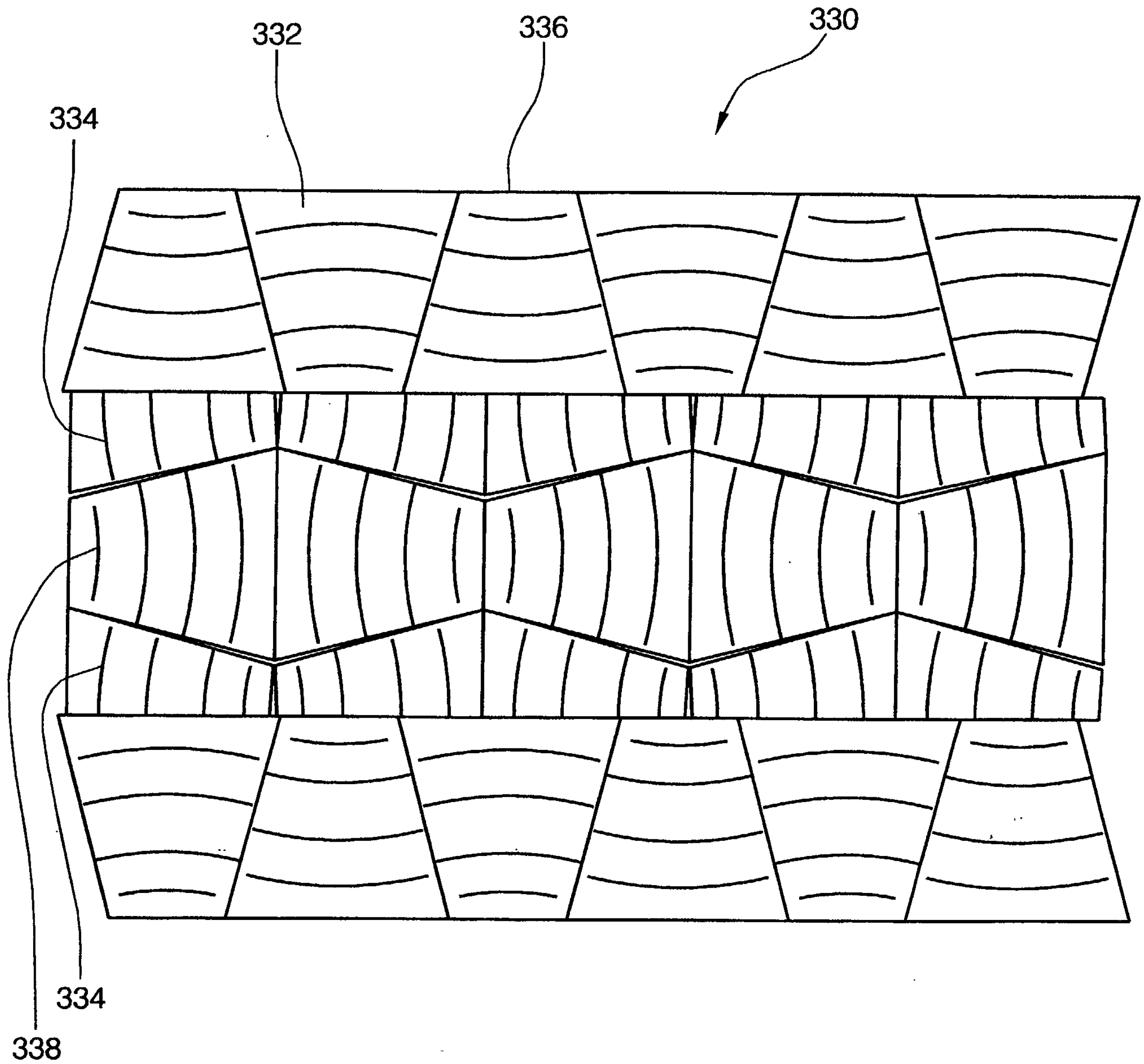

Fig.2o

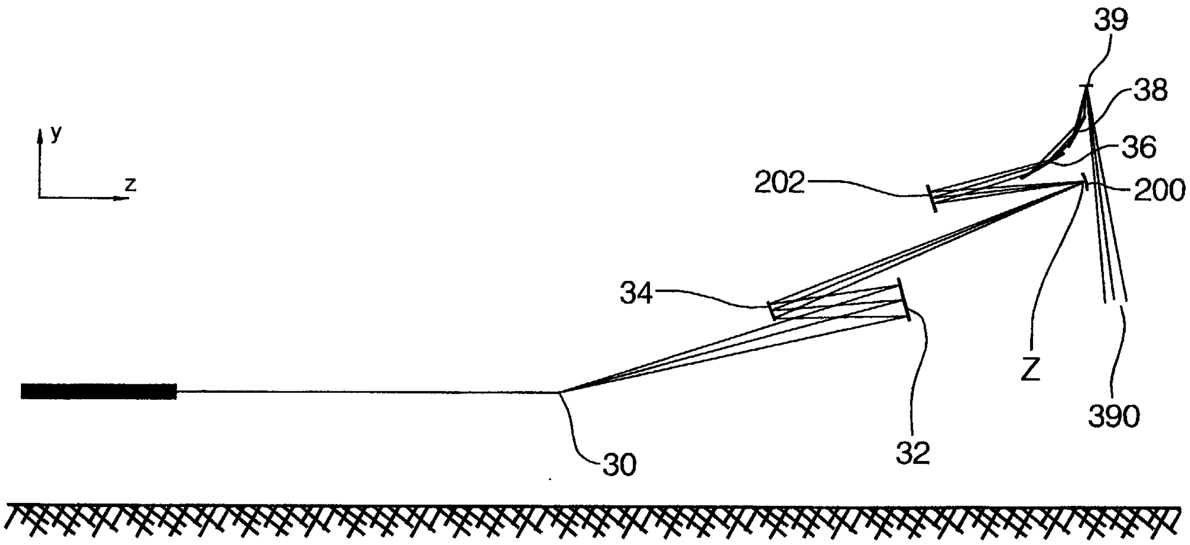

Fig.2p

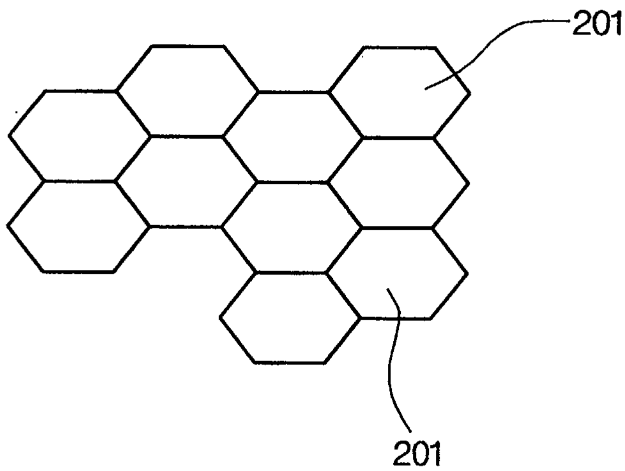


Fig.2q

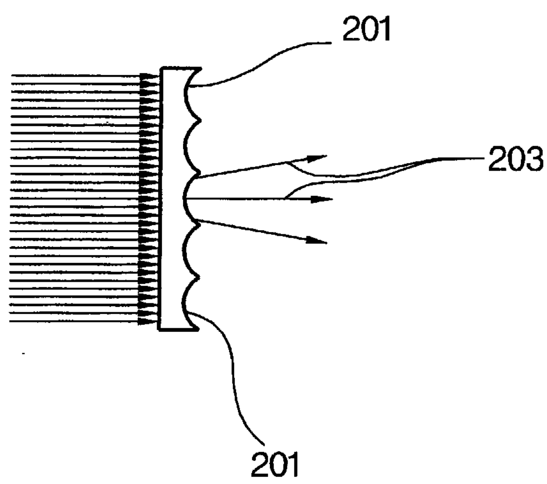

Fig.3

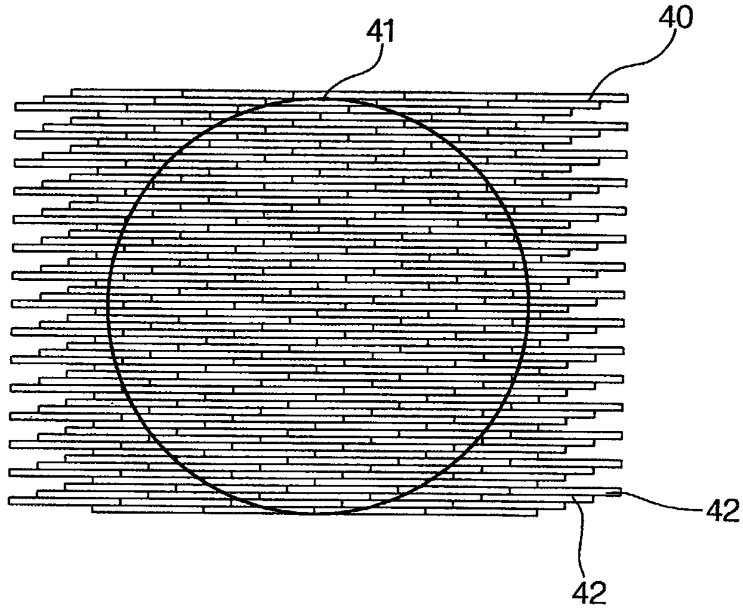


Fig.4a

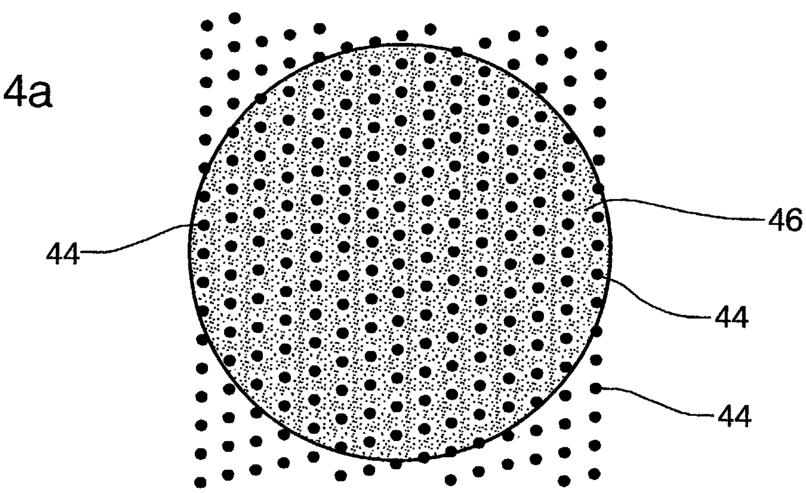


Fig.5

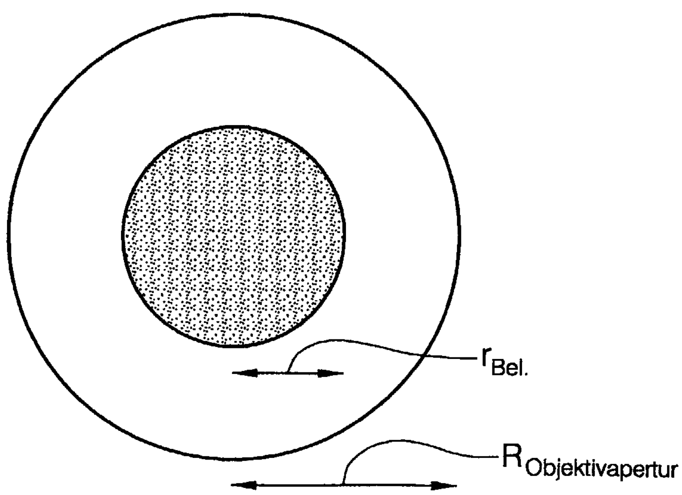

Fig.4b

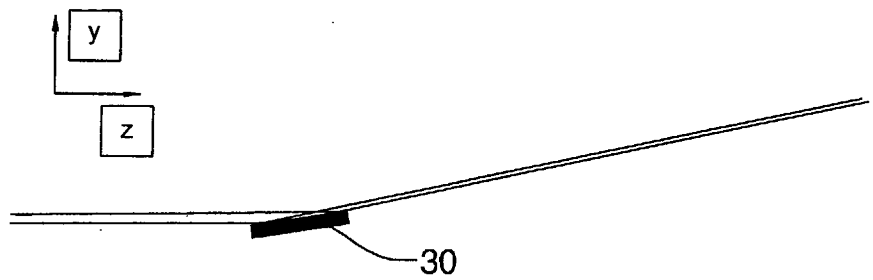


Fig.4c

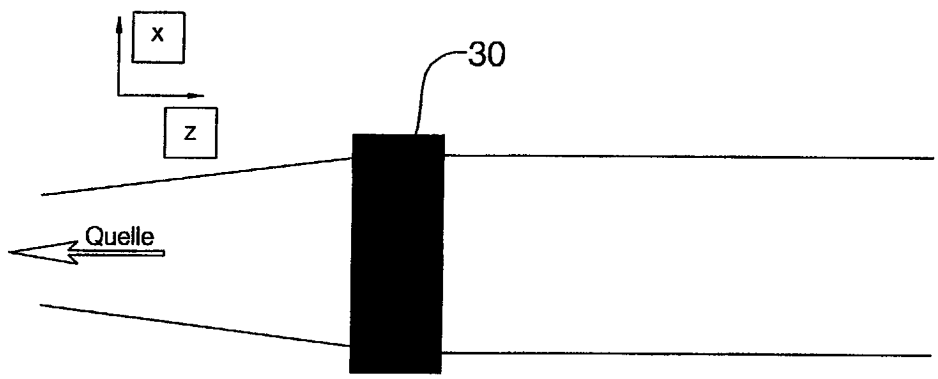


Fig.4d

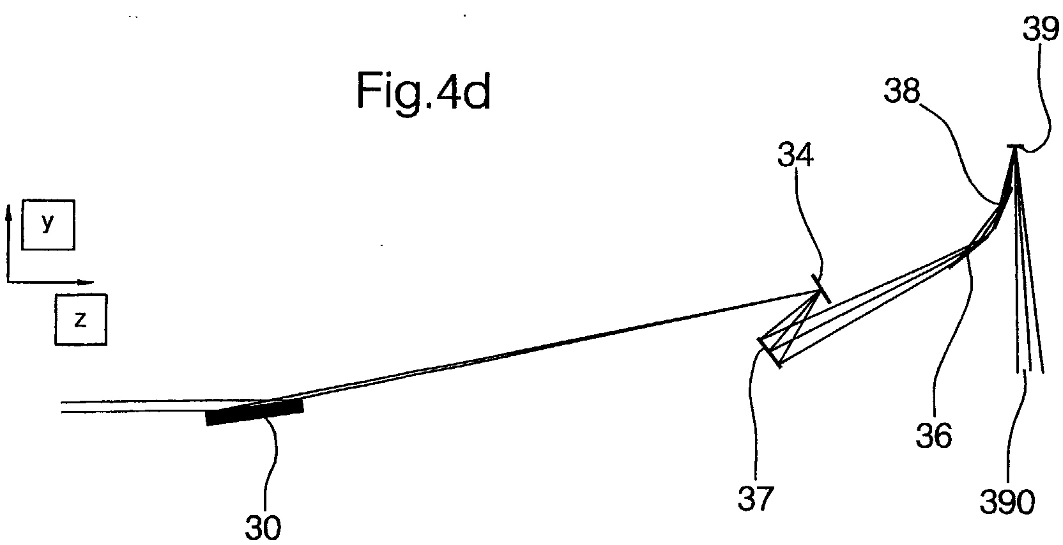

Fig.4e

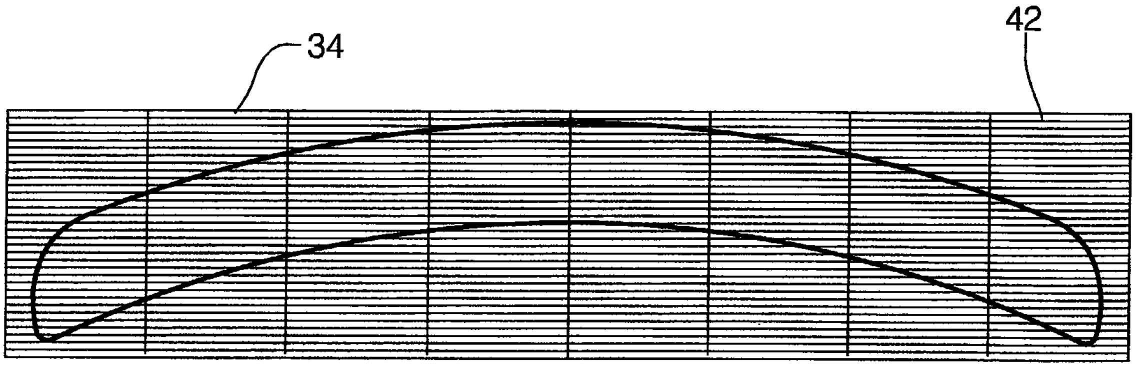


Fig.4f

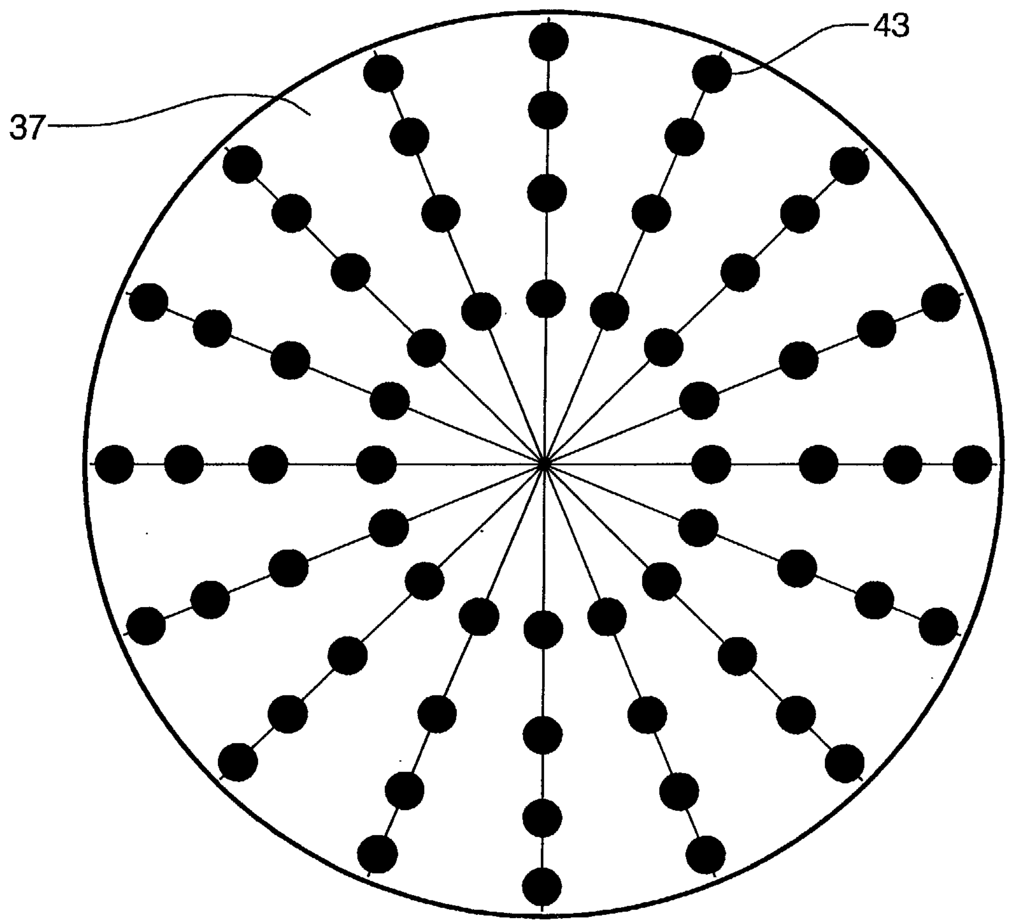

Fig.4g

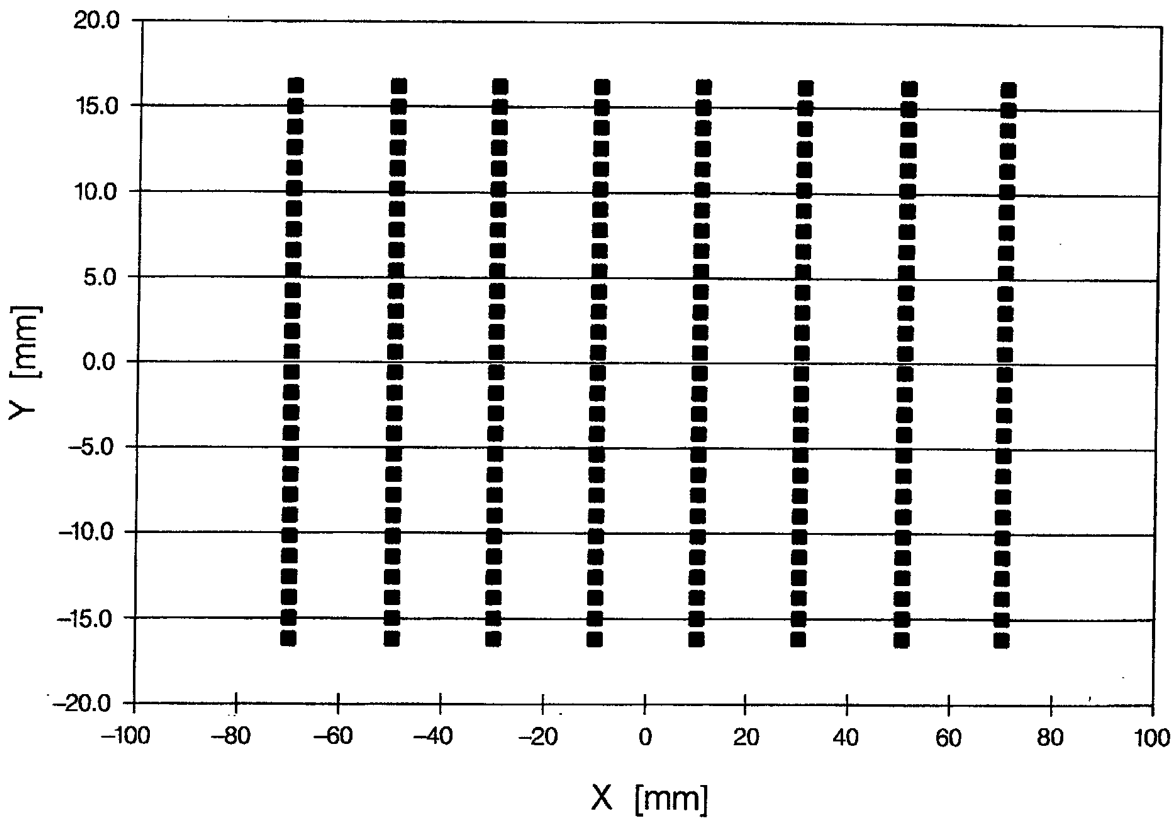
20.0
15.0
10.0
5.0
0.0
–5.0
–10.0
–15.0
–20.0
Y [mm]
–100
–80
–60
–40
–20
0
20
40
60
80
100
X [mm]

Fig.4h

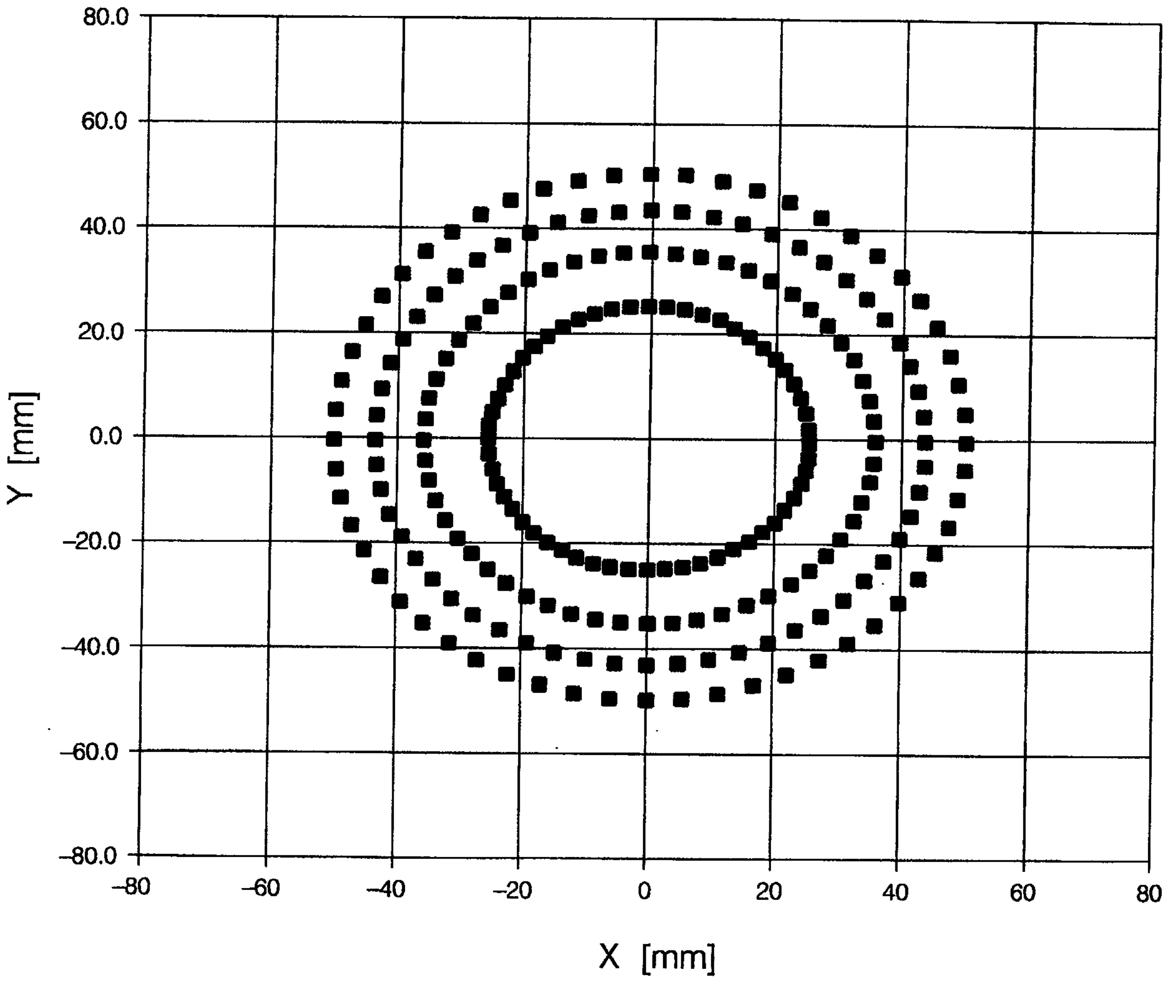

Fig.4i

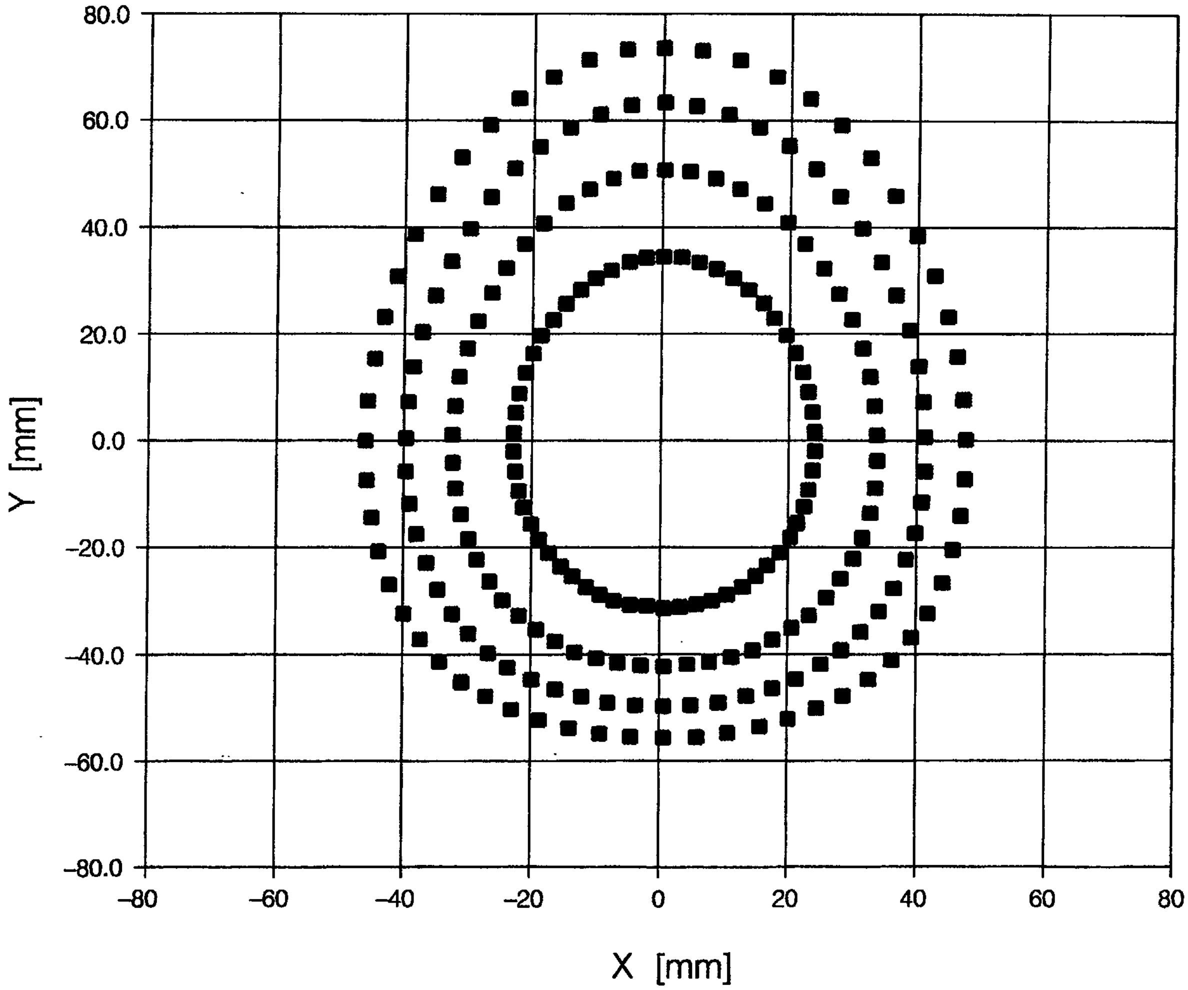

Fig.4k

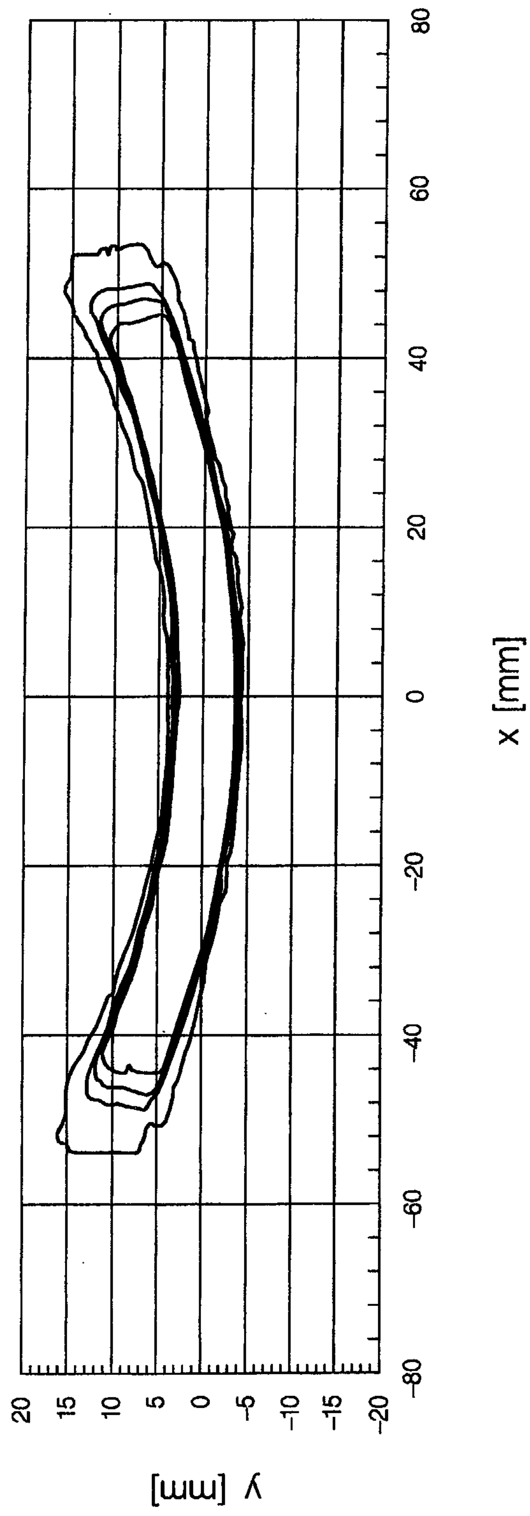

Fig. 4l

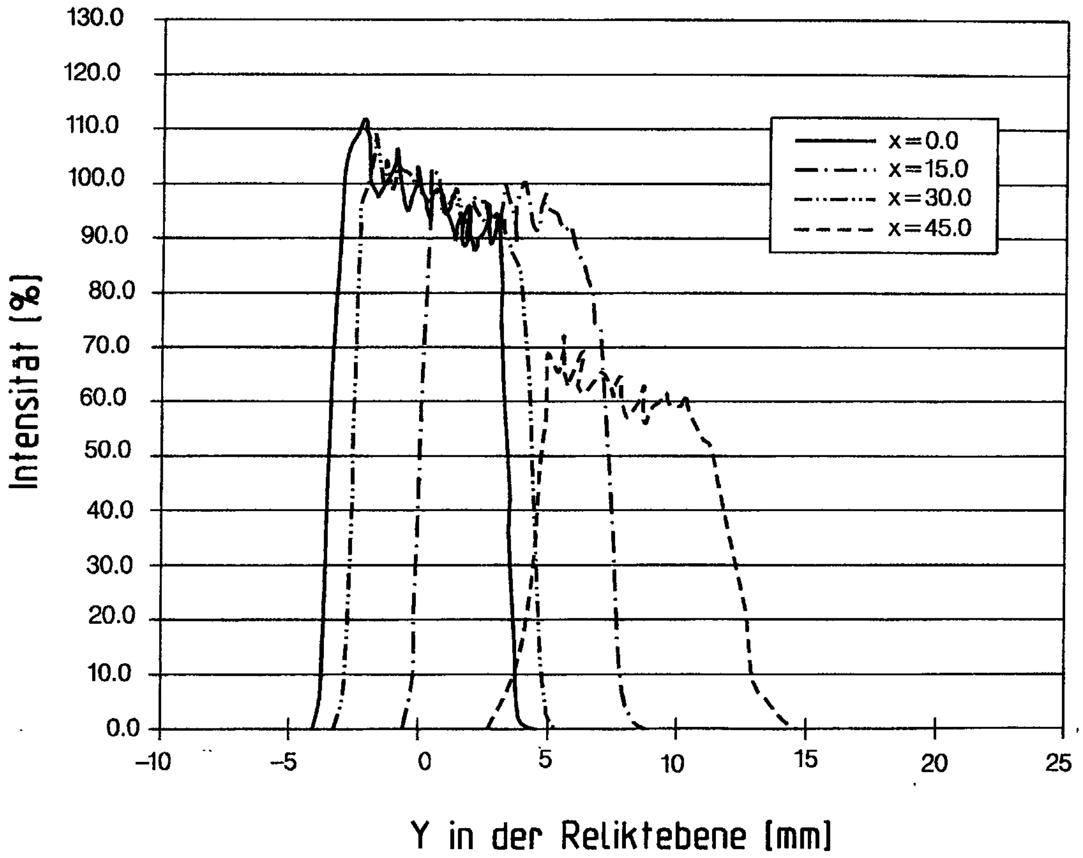
130.0
120.0
110.0
100.0
90.0
80.0
70.0
60.0
50.0
40.0
30.0
20.0
10.0
0.0
Intensität [%]
x=0.0
x=15.0
x=30.0
x=45.0
-10
-5
0
5
10
15
20
25
Y in der Reliktebene [mm]

Fig.4m

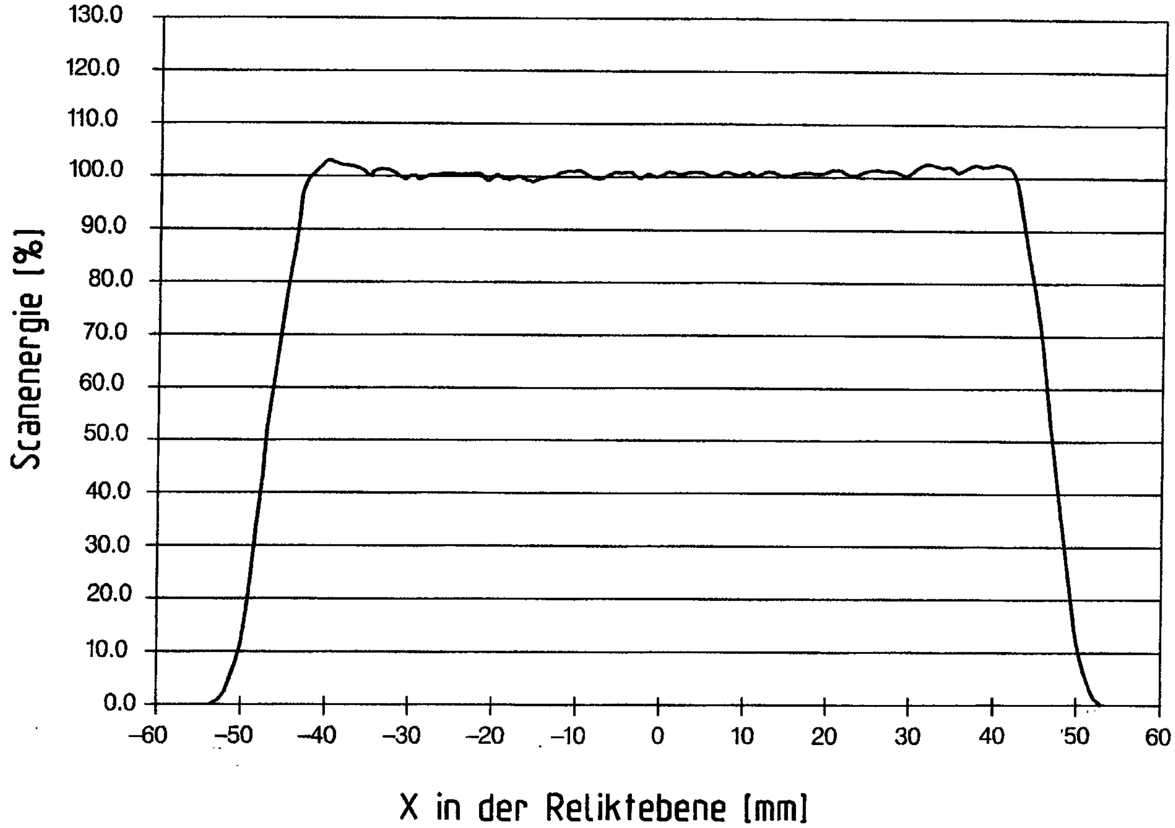
130.0
120.0
110.0
100.0
90.0
80.0
70.0
60.0
50.0
40.0
30.0
20.0
10.0
0.0
Scanenergie [%]
-60
-50
-40
-30
-20
-10
0
10
20
30
40
50
60
X in der Reliktebene [mm]

Fig.6a

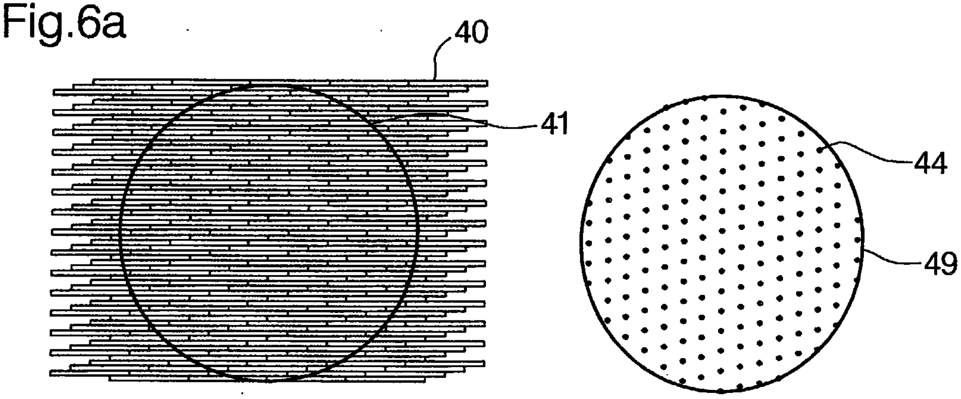


Fig.6b

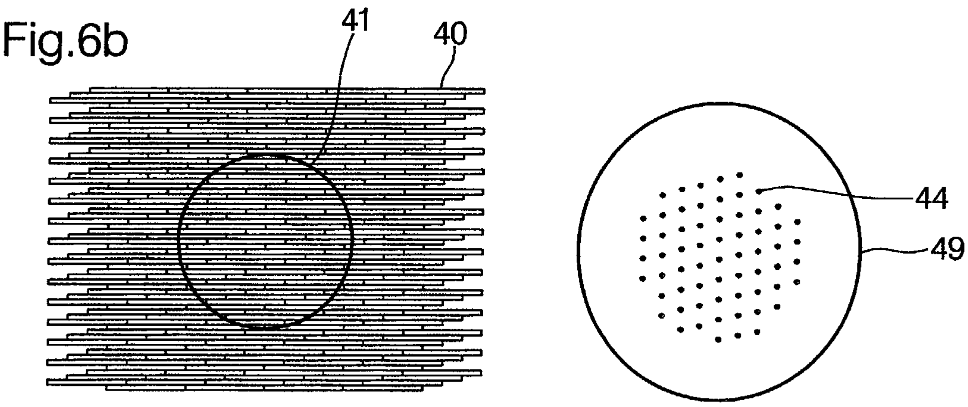


Fig.6c

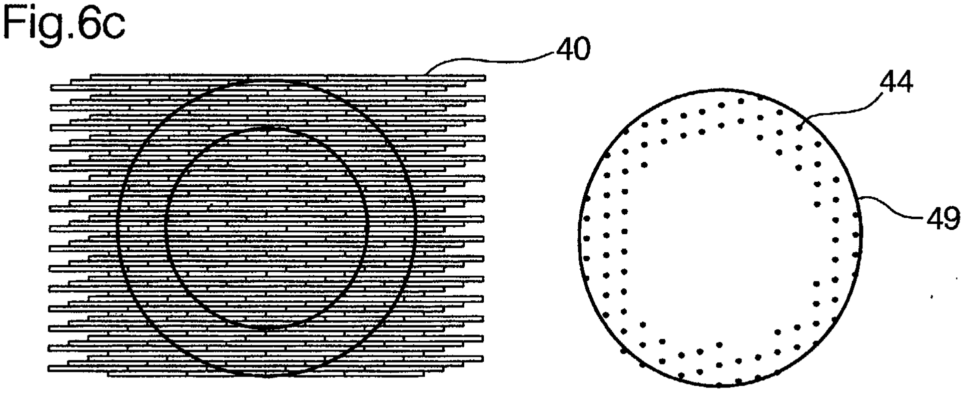


Fig.6d

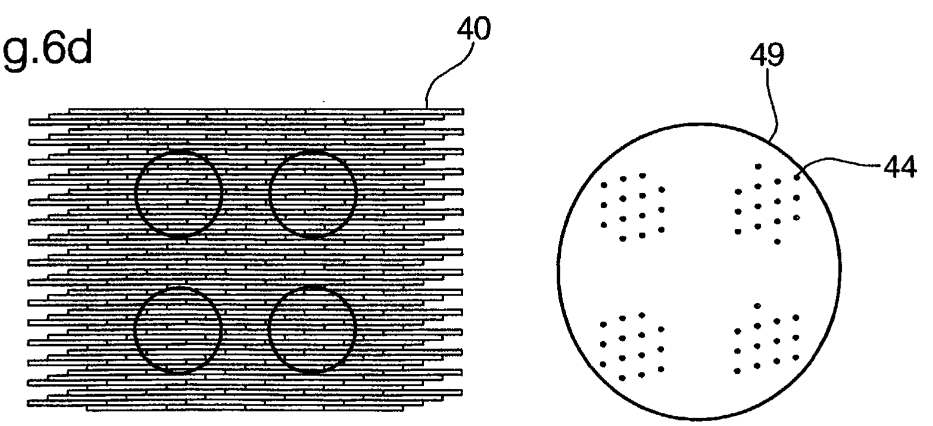

Fig.7

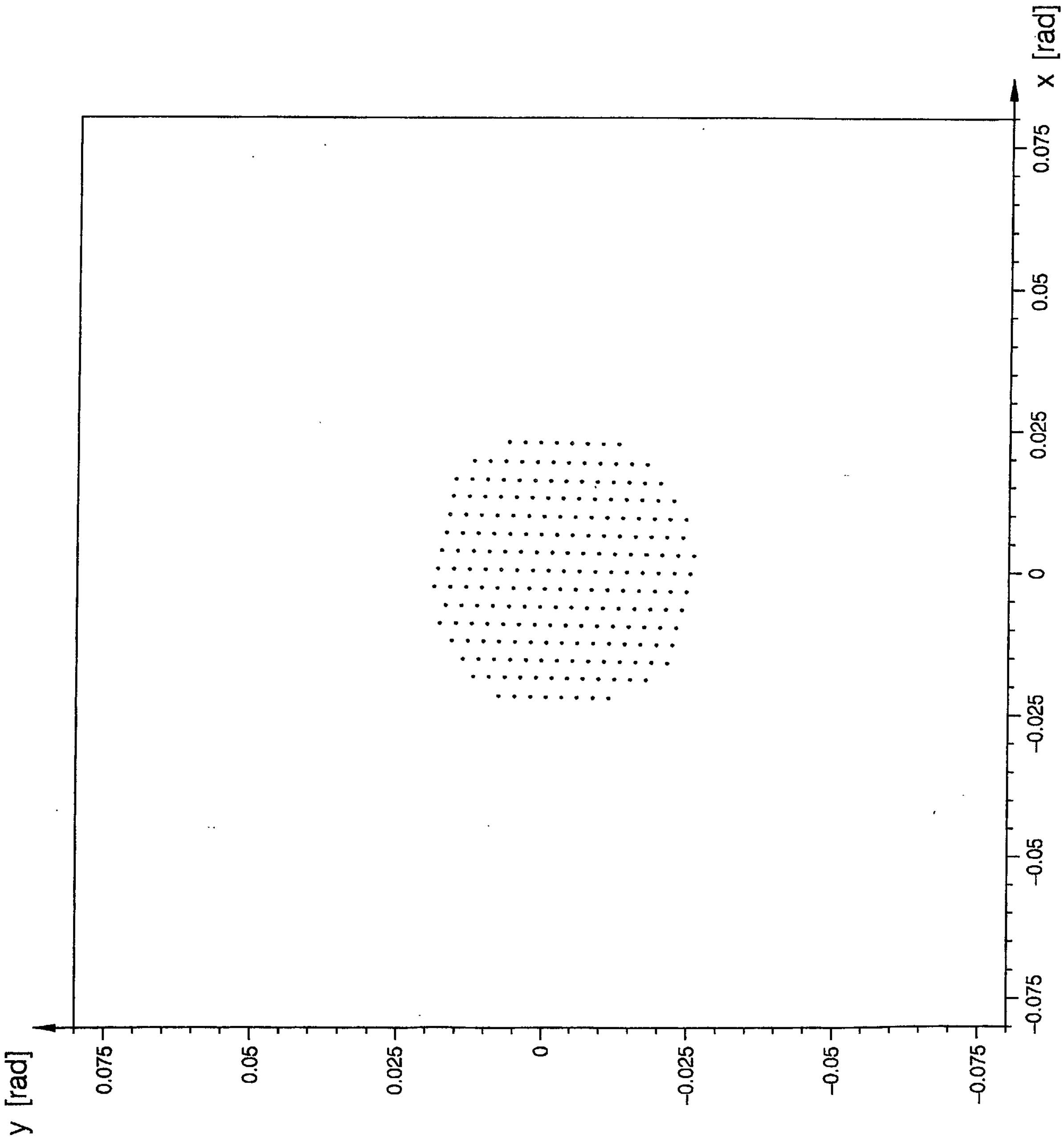

x [rad]
0.075
0.05
0.025
0
-0.025
-0.05
-0.075
y [rad]
0.075
0.05
0.025
0
-0.025
-0.05
-0.075

Fig.8

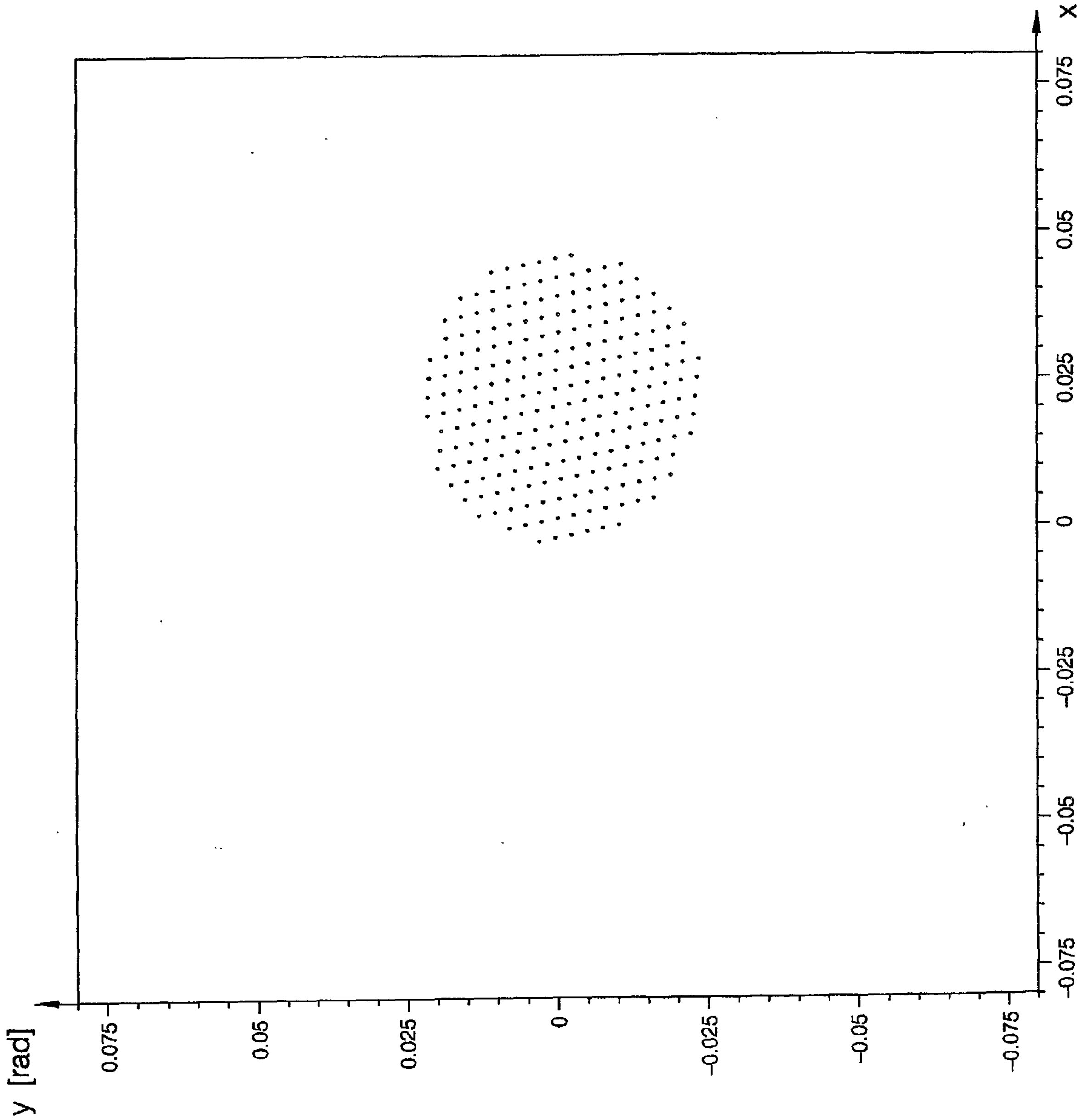
x [rad]
0.075
0.05
0.025
0
-0.025
-0.05
-0.075
y [rad]
0.075
0.05
0.025
0
-0.025
-0.05
-0.075

Fig.9

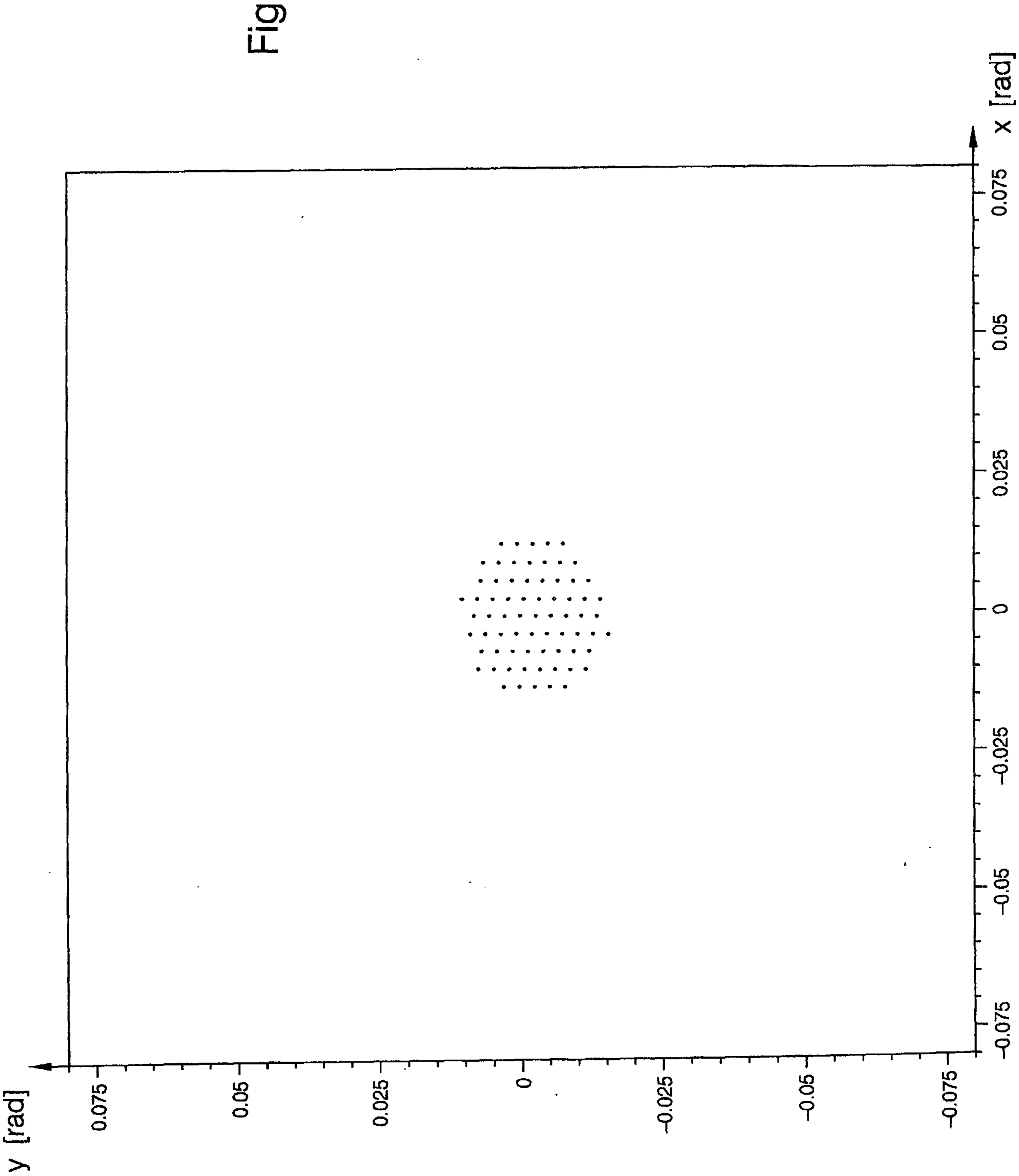
x [rad]
0.075
0.05
0.025
0
−0.025
−0.05
−0.075
y [rad]
0.075
0.05
0.025
0
−0.025
−0.05
−0.075

Fig.10

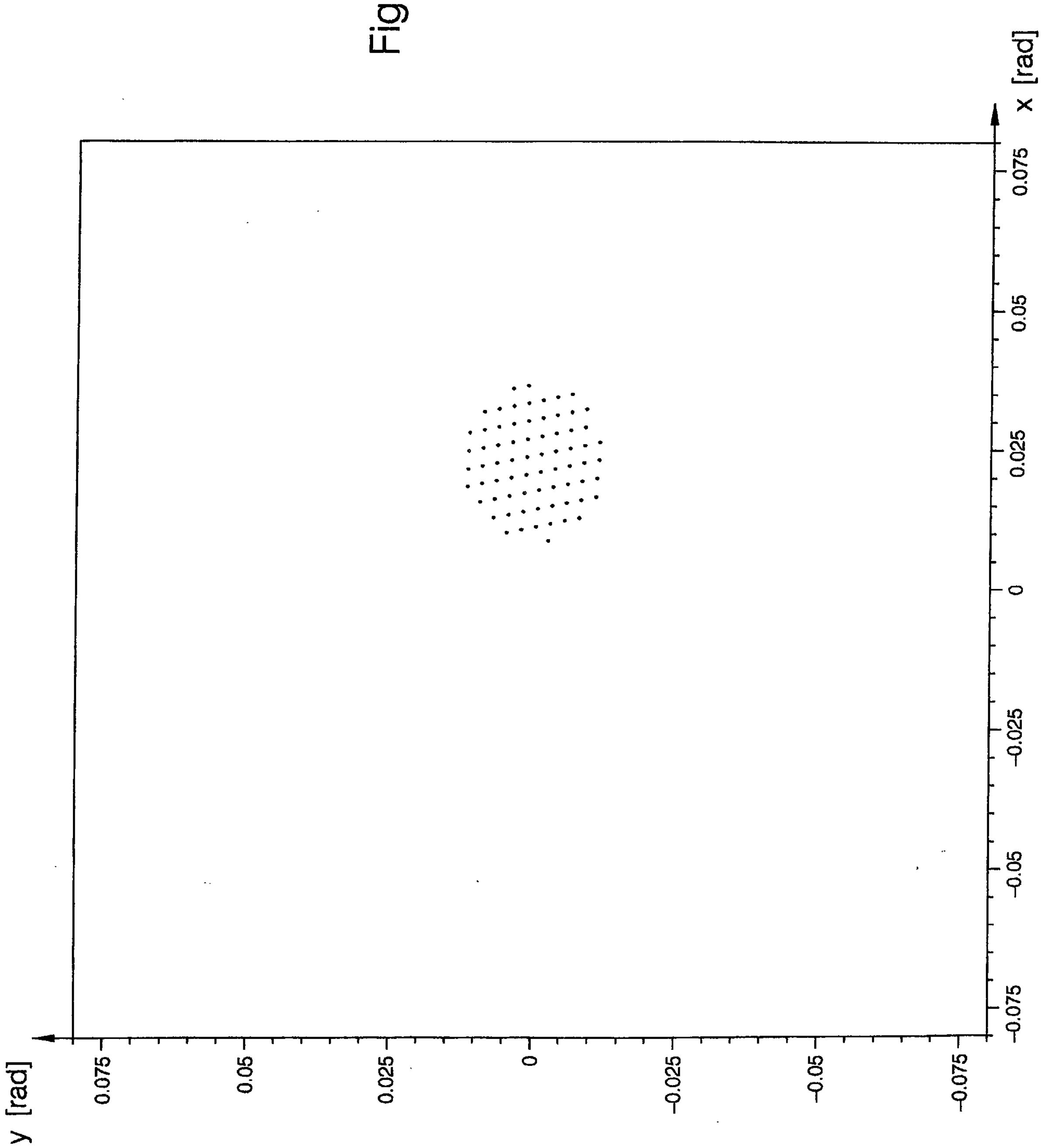

Fig.11

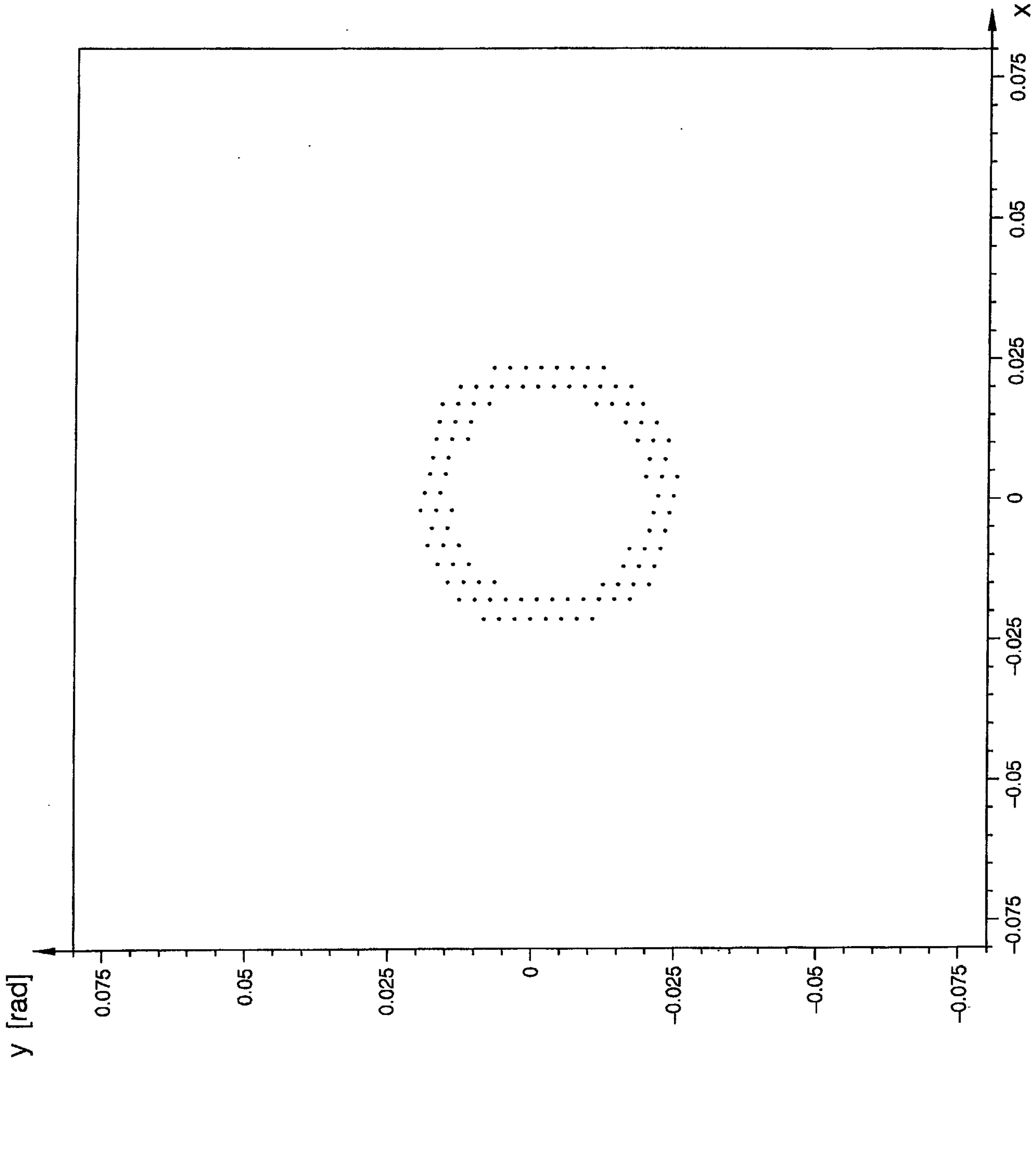

Fig.12

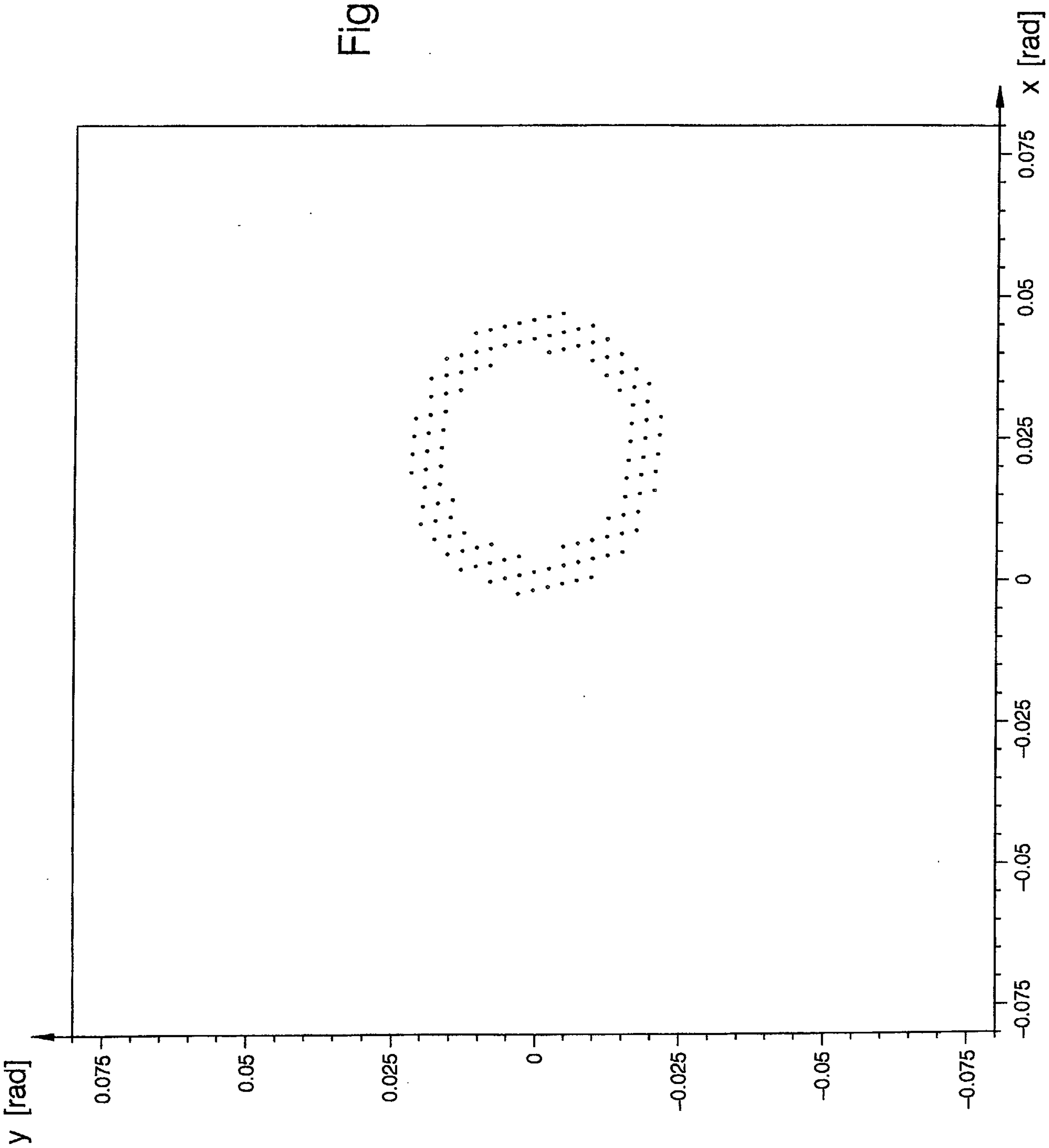

Fig.13

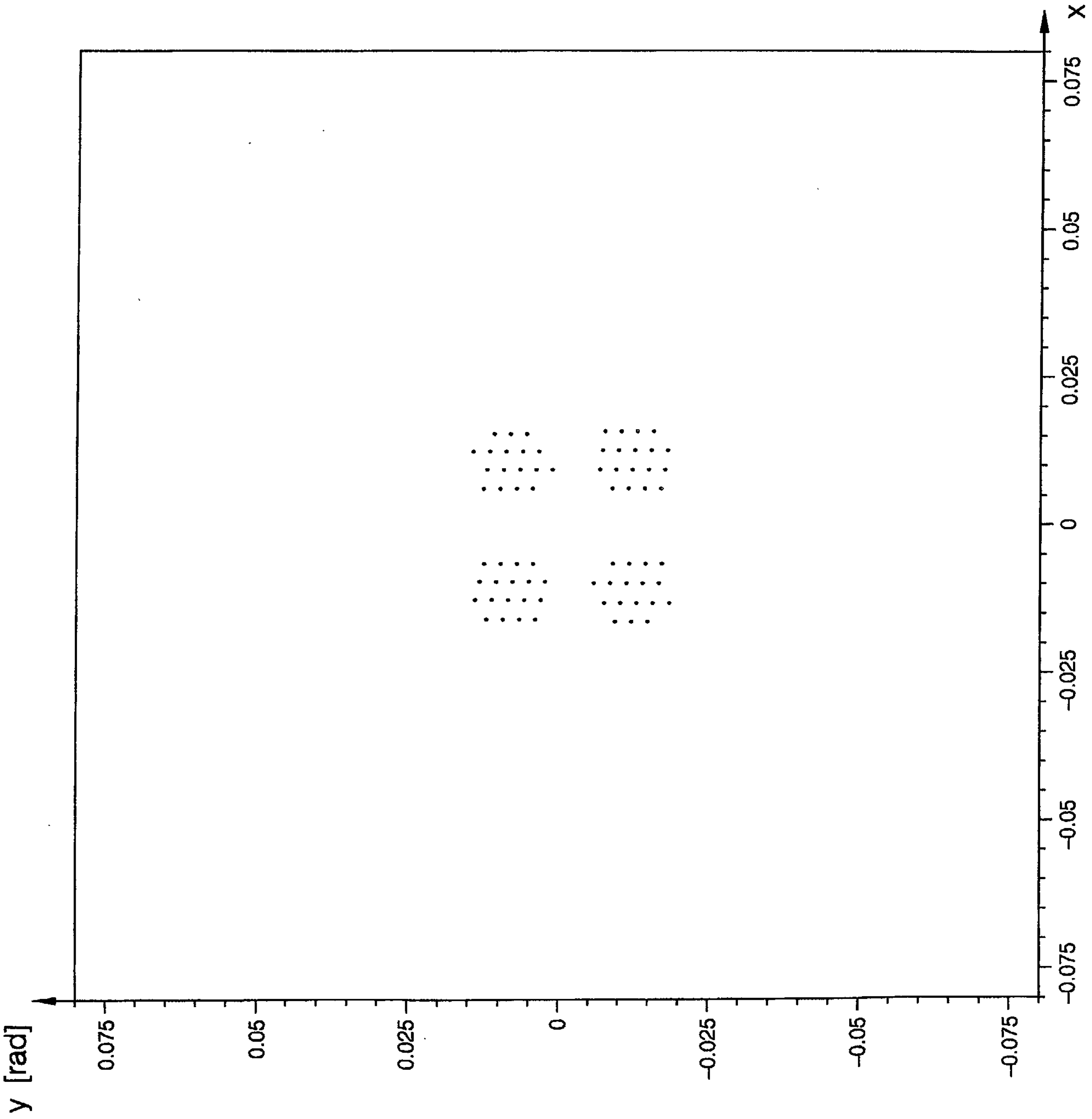
x [rad]
0.075
0.05
0.025
0
-0.025
-0.05
-0.075
y [rad]
0.075
0.05
0.025
0
-0.025
-0.05
-0.075

Fig.14

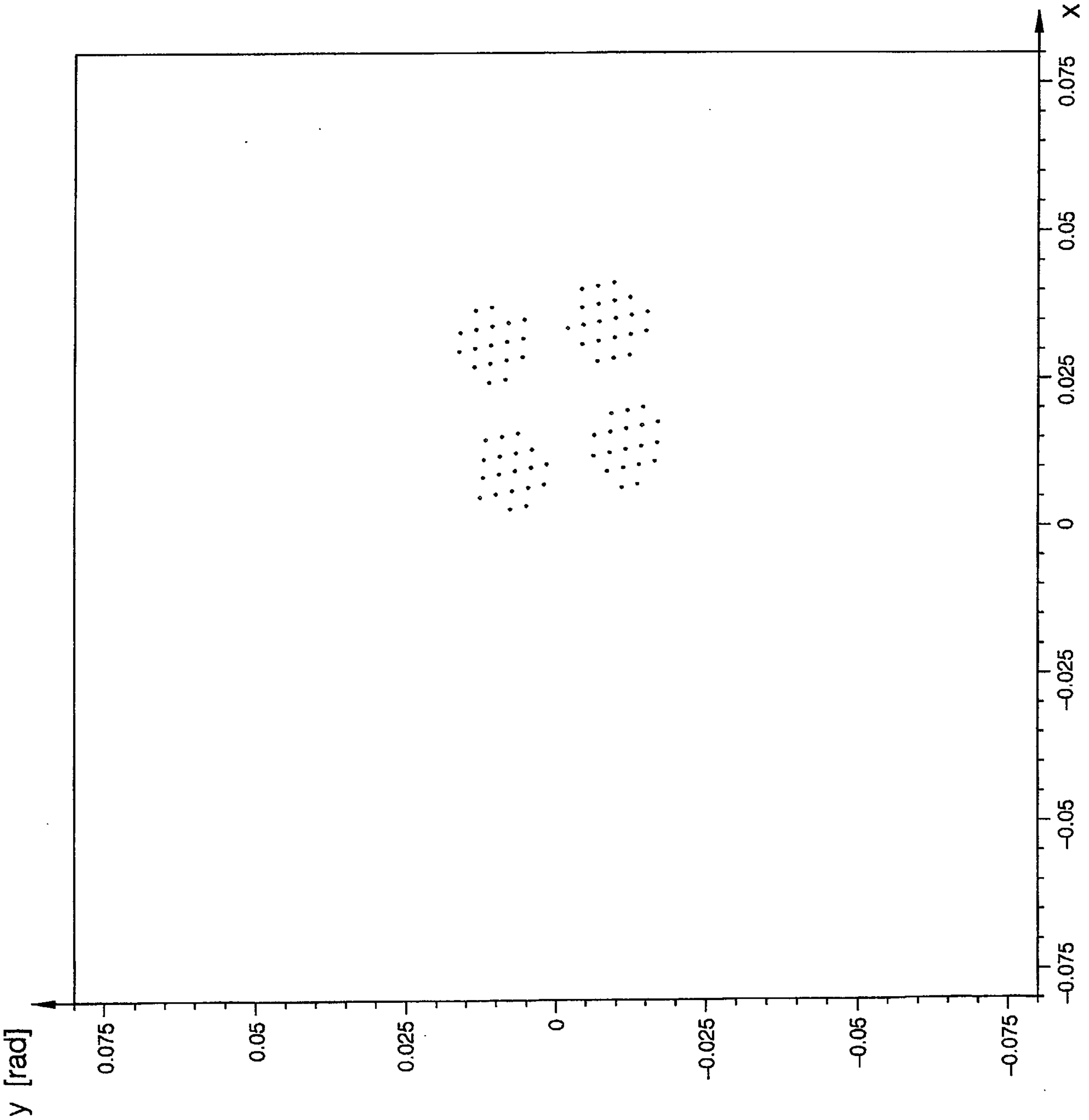
x [rad]
0.075
0.05
0.025
0
−0.025
−0.05
−0.075
y [rad]
0.075
0.05
0.025
0
−0.025
−0.05
−0.075

Fig.15

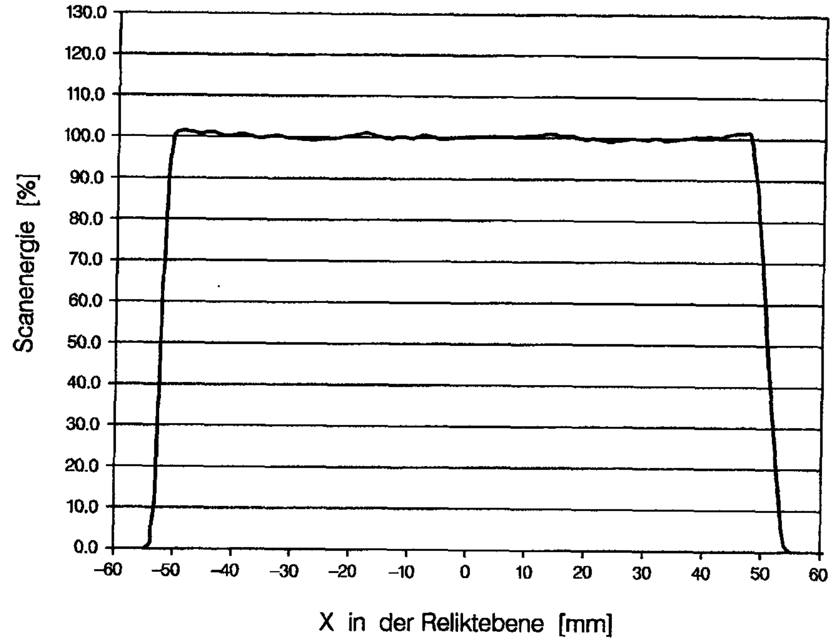
130.0
120.0
110.0
100.0
90.0
80.0
70.0
60.0
50.0
40.0
30.0
20.0
10.0
0.0
Scanenergie [%]
-60
-50
-40
-30
-20
-10
0
10
20
30
40
50
60
X in der Reliktebene [mm]

Fig.16

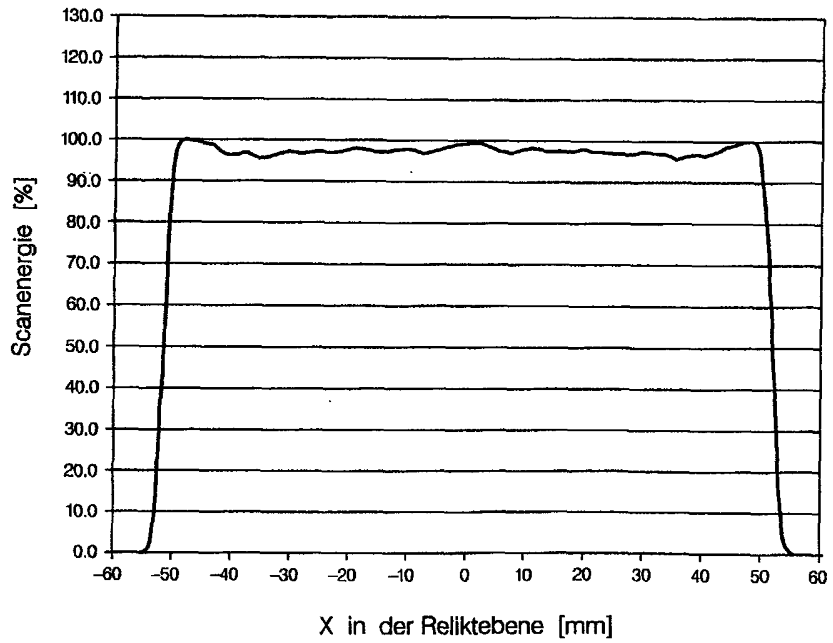
130.0
120.0
110.0
100.0
90.0
80.0
70.0
60.0
50.0
40.0
30.0
20.0
10.0
0.0
Scanenergie [%]
-60
-50
-40
-30
-20
-10
0
10
20
30
40
50
60
X in der Reliktebene [mm]

Fig.17

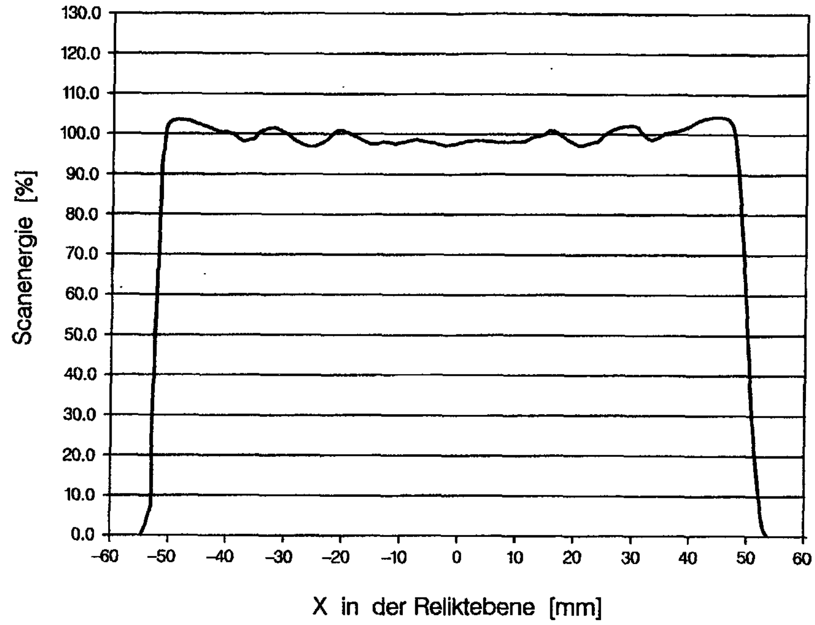
130.0
120.0
110.0
100.0
90.0
80.0
70.0
60.0
50.0
40.0
30.0
20.0
10.0
0.0
Scanenergie [%]
-60 -50 -40 -30 -20 -10 0 10 20 30 40 50 60
X in der Reliktebene [mm]

Fig.18

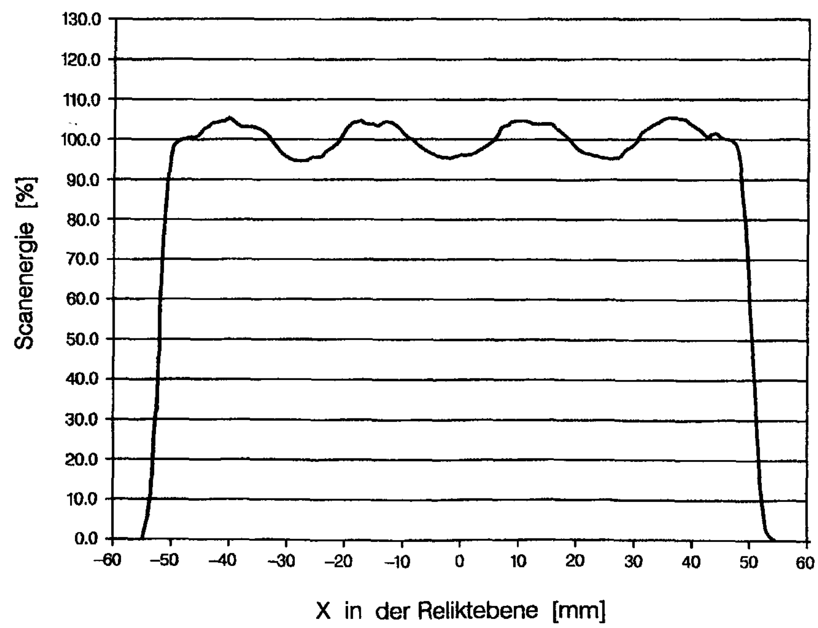
130.0
120.0
110.0
100.0
90.0
80.0
70.0
60.0
50.0
40.0
30.0
20.0
10.0
0.0
Scanenergie [%]
-60 -50 -40 -30 -20 -10 0 10 20 30 40 50 60
X in der Reliktebene [mm]

Fig.19

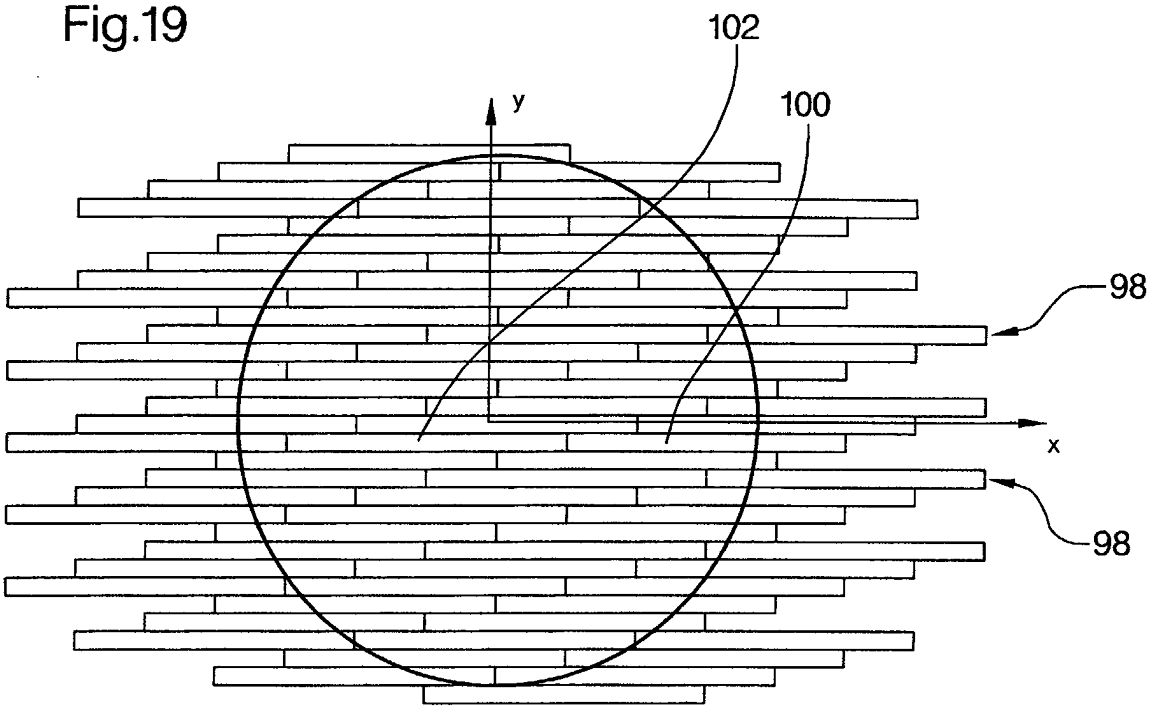


Fig.20

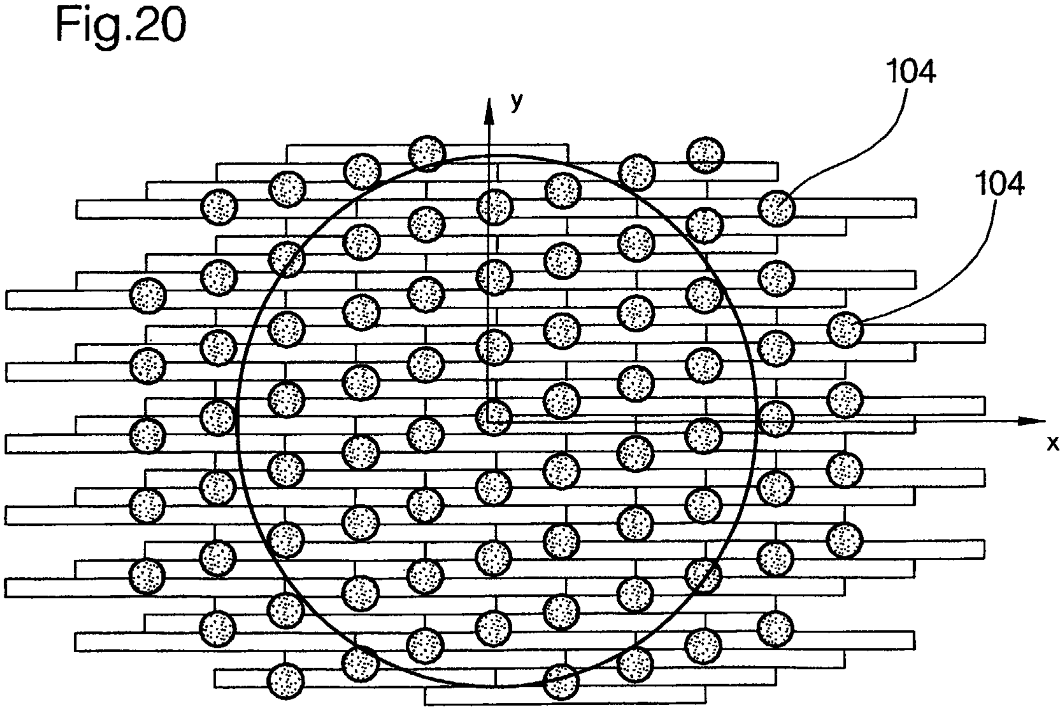

Fig.21

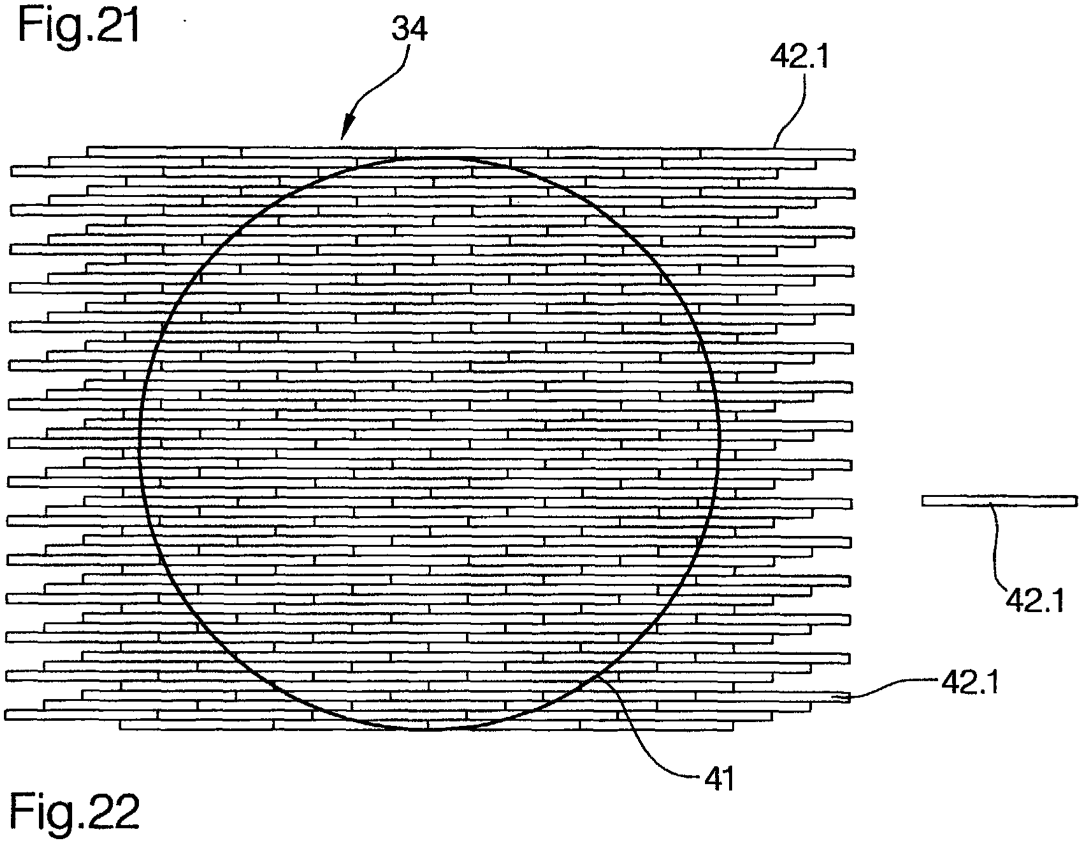


Fig.22

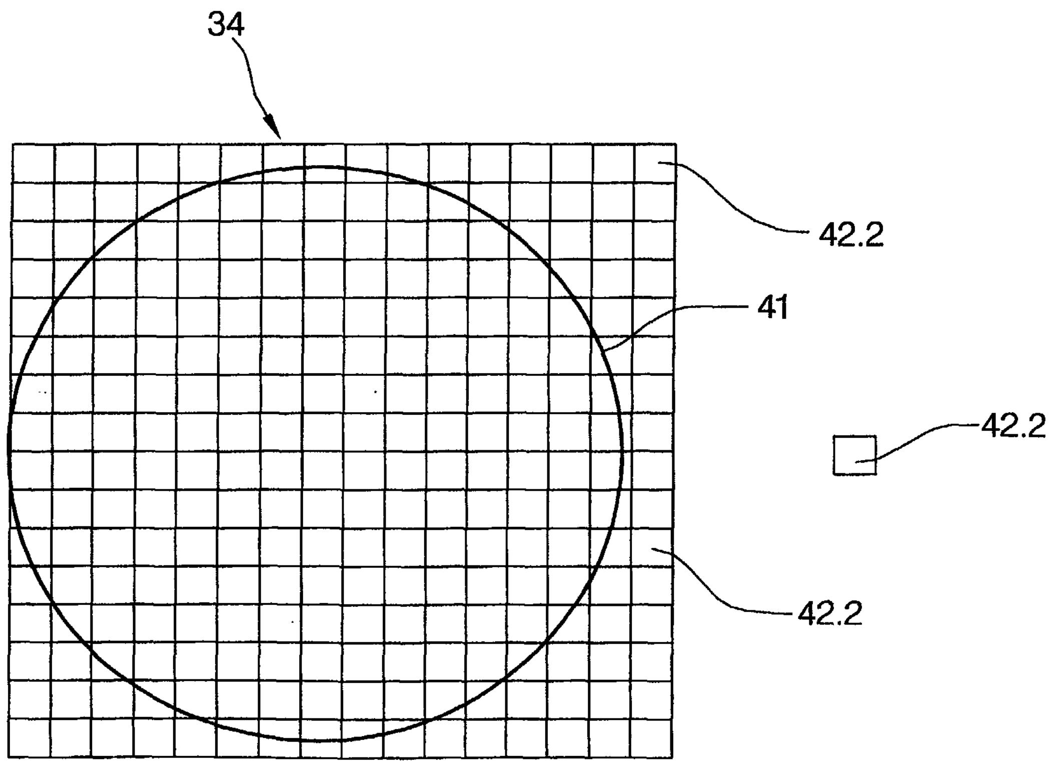

Europäisches Patentamt

# EUROPÄISCHER RECHERCHENBERICHT

Nummer der Anmeldung
EP 02 00 8198

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| D,A | US 5 896 438 A (MIYAKE AKIRA ET AL) 20. April 1999 (1999-04-20) * Spalte 5, Zeile 47 - Zeile 53 * * Spalte 7, Zeile 28 - Spalte 8, Zeile 24 * * Abbildungen 1,5,6 * | 1,17,19 | G03F7/20 |
| D,A | US 5 581 605 A (TANITSU OSAMU ET AL) 3. Dezember 1996 (1996-12-03) * Spalte 17, Zeile 35 - Spalte 19, Zeile 55 * * Spalte 46, Zeile 61 - Spalte 48, Zeile 41 * * Abbildungen 28,53A,54A * | 1,17,19 | |
| D,A | US 5 825 844 A (MIYAKE AKIRA ET AL) 20. Oktober 1998 (1998-10-20) * Spalte 8, Zeile 15 - Zeile 58 * * Abbildungen 10,11 * | 1,17,19 | |
| D,A | PATENT ABSTRACTS OF JAPAN vol. 017, no. 448 (P-1594), 17. August 1993 (1993-08-17) -& JP 05 100097 A (NIKON CORP), 23. April 1993 (1993-04-23) * Zusammenfassung; Abbildungen * | 1,17,19 | RECHERCHIERTE SACHGEBIETE (Int.Cl.7) G03F |

Der vorliegende Recherchenbericht wurde für alle Patentansprüche erstellt

| Recherchenort | Abschlußdatum der Recherche | Prüfer |
|---|---|---|
| DEN HAAG | 16. Juli 2002 | Heryet, C |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie,übereinstimmendes Dokument

EPO FORM 1503 03.82 (P04C03)

## ANHANG ZUM EUROPÄISCHEN RECHERCHENBERICHT ÜBER DIE EUROPÄISCHE PATENTANMELDUNG NR. EP 02 00 8198

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

16-07-2002

| Im Recherchenbericht angeführtes Patentdokument | Datum der Veröffentlichung | Mitglied(er) der Patentfamilie | Datum der Veröffentlichung |
|---|---|---|---|
| US 5896438 A | 20-04-1999 | JP 3284045 B2 | 20-05-2002 |
| | | JP 9298140 A | 18-11-1997 |
| US 5581605 A | 03-12-1996 | JP 6235797 A | 23-08-1994 |
| | | JP 3144175 B2 | 12-03-2001 |
| | | JP 7084108 A | 31-03-1995 |
| | | JP 7094397 A | 07-04-1995 |
| | | JP 7249561 A | 26-09-1995 |
| | | US 5669708 A | 23-09-1997 |
| US 5825844 A | 20-10-1998 | JP 3278317 B2 | 30-04-2002 |
| | | JP 8262210 A | 11-10-1996 |
| JP 05100097 A | 23-04-1993 | JP 3010844 B2 | 21-02-2000 |

EPO FORM P0461

Für nähere Einzelheiten zu diesem Anhang : siehe Amtsblatt des Europäischen Patentamts, Nr.12/82